(19) Europäisches Patentamt
European Patent Office
Office européen des brevets

(11) **EP 4 685 727 A1**

(12) **EUROPEAN PATENT APPLICATION**
published in accordance with Art. 153(4) EPC

(43) Date of publication:
**28.01.2026 Bulletin 2026/05**

(21) Application number: **23928783.2**

(22) Date of filing: **11.12.2023**

(51) International Patent Classification (IPC):
**G06Q 50/02** (2024.01)

(52) Cooperative Patent Classification (CPC):
**G06Q 50/02; Y02A 40/25**

(86) International application number:
**PCT/JP2023/044185**

(87) International publication number:
**WO 2024/195216 (26.09.2024 Gazette 2024/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **22.03.2023 JP 2023045333**

(71) Applicant: **Seiwa Company, Limited Shimotsuke-shi, Tochigi 329-0412 (JP)**

(72) Inventors:
• **NIIMURA Subaru**
  **Shimotsuke-shi, Tochigi 329-0412 (JP)**
• **ODE Hironobu**
  **Shimotsuke-shi, Tochigi 329-0412 (JP)**

(74) Representative: **Hoffmann Eitle Patent- und Rechtsanwälte PartmbB Arabellastraße 30 81925 München (DE)**

(54) **RESOURCE RECYCLING GREENHOUSE HORTICULTURE SIMULATION DEVICE, COMPUTER PROGRAM, AND RECORDING MEDIUM**

(57) There is provided a resource-recycling greenhouse horticulture simulation apparatus which promotes recycling use of exhaust heat and an exhaust gas to allow a contribution to a reduction in greenhouse effect gas.

There are included: an exhaust heat-recycling simulation unit 10 in a case of recovering exhaust heat to use it for heating; and an exhaust gas-recycling simulation unit 20 in a case of using carbon dioxide obtained by recovering an exhaust gas for growth promotion of the plant. A greenhouse effect gas reduction amount by using the exhaust heat can be simulated by an exhaust heat-use greenhouse-effect-gas reduction-amount calculation unit 12, and a greenhouse effect gas emission amount by using the exhaust gas can be simulated by an exhaust gas-use greenhouse-effect-gas reduction-amount calculation unit 22.

FIG. 4

**Description**

Technical Field

The present invention relates to a technique capable of simulating an effect in carrying out resource-recycling greenhouse horticulture using exhaust heat and an exhaust gas.

Background Art

Various countermeasures against global warming are being studied as a pressing issue. In particular, a reduction in greenhouse effect gas in power stations, substations, factories, incineration plants, and the like which emit the greenhouse effect gas such as carbon dioxide can be expected to have a great effect on the countermeasures against global warming.

Patent Document 1 discloses a waste combined-incineration treatment system composed of an incineration treatment system equipped with an incinerator which subjects waste such as municipal waste, sewage sludge, and industrial waste to incineration treatment, and a methane fermentation treatment system equipped with a methane fermentation tank which subjects wet waste to methane fermentation treatment. Resource saving is attempted through reuse in the system, such as use of, by recovering and separating a methane gas and carbon dioxide, this separated carbon dioxide for cleaning ash produced in the incineration treatment system.

Patent Document 2 discloses a technique in which heat exhaust air containing a large amount of carbon dioxide of thermal power stations is not emitted to the air, and heat exchange to cause a drop to a predetermined temperature by using seawater is performed, and this heat exhaust air containing carbon dioxide is supplied to a plant factory to inhibit the emission to the air of the greenhouse effect gas.

Patent Document 3 discloses a technique of separating carbon dioxide from an exhaust gas emitted from thermal power stations, garbage incineration plants, and the like using a water film provided with a carbon dioxide absorption capacity, and also describes that the separated carbon dioxide is used for plant growth, thereby being used effectively without emitting carbon dioxide into the air to solve global environment problems.

Non-Patent Document 1 discloses, as one of global warming prevention techniques, a technique of supplying heat generated by combustion of gas or the like to a greenhouse to provide heating, and taking out carbon dioxide from an exhaust gas and supplying it to promote growth of plants.

Prior Art Document

Patent Document

    Patent Document 1: Japanese Patent Application Laid-open No. 2006-212524
    Patent Document 2: Japanese Patent Application Laid-open No. 3-236723
    Patent Document 3: Japanese Patent Application Laid-open No. 2021-133314

Non-Patent Document

Non-Patent Document 1: ene-fro, ENERGY FRONTLINE, April 13th, 2021, Vol. 25, "Tomato grows more and more rapidly with CO2! What is the latest technology of killing three birds with one stone?" URL: https://ene-fro.com/article/ef195_a1/

Summary of the Invention

Problems to Be Solved by the Invention

The techniques disclosed in Patent Documents 1 to 3 and Non-Patent Document 1 are techniques of basically inhibiting an emission amount of a greenhouse effect gas into the air by recovering carbon dioxide and heat emitted from various energy emission facilities and using them for other uses. Among these, most of thermal energy of exhaust heat is heat derived from fossil fuels, and a use amount of the fossil fuels can be reduced by promoting its use, which leads to energy saving and a reduction in greenhouse effect gas emission amount.

However, the above-described conventional techniques have findings of the use itself of the thermal energy of the exhaust heat, but a sufficient study of more efficient use of the thermal energy in a greenhouse has not been made.

Actually, it is the present situation that the evaluation in which the exhaust heat or the like of factories or the like is used by being supplied to the existing greenhouse, which allows a contribution to the energy saving and the reduction in greenhouse effect gas is made alone.

Further, Patent Documents 2 to 3 and Non-Patent Document 1 are common to one another in that an emission amount to the air of carbon dioxide is inhibited by supplying carbon dioxide to plants, but the concept of consuming carbon dioxide by cultivation of the plants is presented alone, and the study of how much carbon dioxide supplied to a greenhouse is absorbed depending on the plants is not made.

In a case of using the exhaust gas for the absorption of carbon dioxide of plants, if it aims to enhance an effect of inhibiting the emission amount of carbon dioxide to the air, it is necessary to construct the greenhouse capable of securing a suitable cultivation area. However, the larger the cultivation area becomes, the more a construction cost, an operation cost, and a maintenance cost of the greenhouse naturally increase.

In the greenhouse scheduled to be constructed, in a case of a configuration to recycle and use the exhaust heat and the exhaust gas, if what degree of possible contribution to emission reduction of the greenhouse effect gas and an economic merit based thereon can be estimated and visualized, they lead to the spread of resource-recycling greenhouse horticulture.

The present invention was made in consideration of the above, and has an object to provide a resource-recycling greenhouse horticulture simulation apparatus which allows simulation of a reduction amount or the like of a greenhouse effect gas in a case of using exhaust heat and an exhaust gas of power stations, factories, and the like for greenhouse horticulture, and promotes recycling use of the exhaust heat and the exhaust gas to allow contribution to the reduction in greenhouse effect gas, and to provide a computer program and a recording medium.

Means for Solving the Problems

To solve the above problems, the present invention provides, a resource-recycling greenhouse horticulture simulation apparatus including: in a case of cultivating a predetermined plant in a greenhouse, an exhaust heat-recycling simulation unit in a case of recovering exhaust heat to use the exhaust heat for heating; and an exhaust gas-recycling simulation unit in a case of using carbon dioxide obtained by recovering an exhaust gas for growth promotion of the plant, wherein: the exhaust heat-recycling simulation unit includes:

an exhaust heat-related greenhouse-effect-gas emission-amount calculation unit which finds a greenhouse effect gas emission amount in a case of securing a required heat quantity for keeping a set night temperature suitable for the plant by using heating equipment operated by combustion of a fossil fuel, and finds a greenhouse effect gas emission amount in a case of securing the required heat quantity by using recovered heat recovered from the exhaust heat; and an exhaust heat-use greenhouse-effect-gas reduction-amount calculation unit which finds a difference between the greenhouse effect gas emission amount in the case of securing the required heat quantity by using the heating equipment and the greenhouse effect gas emission amount in the case of securing the required heat quantity by using the recovered heat recovered from the exhaust heat as an exhaust heat-use greenhouse effect gas reduction amount by using the recovered heat; and

the exhaust gas-recycling simulation unit includes:

an exhaust gas-related greenhouse-effect-gas emission-amount calculation unit which finds a greenhouse effect gas emission amount in a case of providing a supply amount of carbon dioxide supplied into the greenhouse by using a device which generates carbon dioxide by combustion of a fossil fuel as a carbon dioxide supply source, and finds a greenhouse effect gas emission amount in a case of providing the supply amount of the carbon dioxide by using carbon dioxide recovered from the exhaust gas; and an exhaust gas-use greenhouse-effect-gas reduction-amount calculation unit which finds a difference between the greenhouse effect gas emission amount in the case of providing the supply amount of the carbon dioxide using the fossil fuel and the greenhouse effect gas emission amount in the case of providing the supply amount of the carbon dioxide using the exhaust gas as an exhaust gas-use greenhouse effect gas reduction amount by using the carbon dioxide recovered from the exhaust gas.

Preferably, the resource-recycling greenhouse horticulture simulation apparatus includes a total reduction amount calculation unit which adds the exhaust heat-use greenhouse effect gas reduction amount obtained by the exhaust heat-use greenhouse-effect-gas emission-amount calculation unit and the exhaust gas-use greenhouse effect gas reduction amount obtained by the exhaust gas-use greenhouse-effect-gas reduction-amount calculation unit together to find a total reduction amount of a greenhouse effect gas.

Preferably, the exhaust heat-recycling simulation unit includes

an exhaust heat-use reduction cost calculation unit which finds a cost required in the case of securing the required heat quantity by the operation of the heating equipment and a cost required in the case of securing the required heat quantity by using the recovered heat individually, and finds an exhaust heat-use reduction cost from a difference between the costs, and

the exhaust gas-recycling simulation unit includes

an exhaust gas-use reduction cost calculation unit which finds a cost required in the case of providing the supply amount of the carbon dioxide using the fossil fuel and a cost required in the case of providing the supply amount of the carbon dioxide using the exhaust gas individually, and finds an exhaust gas-use reduction cost from a difference between the costs.

Preferably, the resource-recycling greenhouse horticulture simulation apparatus includes
a total reduction cost calculation unit which adds the exhaust heat-use reduction cost obtained by the exhaust heat-use reduction cost calculation unit and the exhaust gas-use reduction cost obtained by the exhaust gas-use reduction cost calculation unit together to find a total reduction cost of energy.

Preferably, the exhaust heat-recycling simulation unit includes

a required heat quantity calculation unit for calculating the required heat quantity used in the exhaust heat-related greenhouse-effect-gas emission-amount calculation unit, and
the required heat quantity calculation unit is
a means of calculating, as the required heat quantity, a periodic heat load during a predetermined cultivation period which is calculated using a daily nighttime heating load found in consideration of a floor area and a coverage area of the greenhouse, to a daily maximum air temperature and a daily minimum air temperature obtained from public weather data of an installation region of the greenhouse.

Preferably, the periodic heat load is found by adding a daily daytime heating load to the daily nighttime heating load.

Preferably, the daily daytime heating load is a value obtained by finding a "daytime indoor set temperature - outside air temperature - indoor solar heat effect temperature" for each predetermined time, and integrating only a positive value in an obtained value.

Preferably, the exhaust gas-related greenhouse-effect-gas emission-amount calculation unit is
a means of finding a difference between the supply amount of the carbon dioxide and an absorption amount of carbon dioxide based on the plant as the greenhouse effect gas emission amount.

Preferably, the exhaust gas-recycling simulation unit includes

an absorption amount calculation unit which calculates the absorption amount of the carbon dioxide used in the exhaust gas-related greenhouse-effect-gas emission-amount calculation unit, and
the absorption amount calculation unit is
a means of finding an amount of net photosynthesis of the plant as the absorption amount of the carbon dioxide based on the plant.

Preferably, the absorption amount calculation unit is configured to find the amount of net photosynthesis using a global solar irradiance amount, a light transmittance of the greenhouse, a light interception rate of a plant, and an indoor carbon dioxide concentration in the greenhouse.

Preferably, a configuration is made such that the indoor carbon dioxide concentration is calculated based on an indoor-outdoor ventilation rate of air in the greenhouse, and the ventilation rate is calculated using a difference between an outdoor specific enthalpy and an indoor specific enthalpy of the greenhouse.

Further, the present invention provides a computer program which causes a computer to function as a resource-recycling greenhouse horticulture simulation apparatus, the computer program causing the computer to execute, by

finding a greenhouse effect gas emission amount in a case of securing a required heat quantity for keeping a set night temperature suitable for a plant cultivated in a greenhouse by using heating equipment operated by combustion of a fossil fuel, and finding a greenhouse effect gas emission amount in a case of securing the required heat quantity by using recovered heat recovered from exhaust heat, and
finding a difference between the greenhouse effect gas emission amount in the case of securing the required heat quantity by using the heating equipment and the greenhouse effect gas emission amount in the case of securing the required heat quantity by using the recovered heat recovered from the exhaust heat as an exhaust heat-use greenhouse effect gas reduction amount by using the recovered heat,
an exhaust heat recycling-use simulation in a case of using the recovered heat recovered from the exhaust heat for heating, and

the computer program causing the computer to execute, by

finding a greenhouse effect gas emission amount in a case of providing a supply amount of carbon dioxide supplied into the greenhouse by using a device which generates carbon dioxide by combustion of a fossil fuel as a carbon dioxide supply source, and finding a greenhouse effect gas emission amount in a case of providing the supply amount of the carbon dioxide by using carbon dioxide recovered from an exhaust gas, and

finding a difference between the greenhouse effect gas emission amount in the case of providing the supply amount of the carbon dioxide using the fossil fuel and the greenhouse effect gas emission amount in the case of providing the supply amount of the carbon dioxide using the exhaust gas as an exhaust gas-use greenhouse effect gas reduction amount by using the carbon dioxide recovered from the exhaust gas,

an exhaust gas recycling-use simulation in a case of using the carbon dioxide recovered from the exhaust gas for growth promotion of the plant.

Preferably, the exhaust heat-use greenhouse effect gas reduction amount and the exhaust gas-use greenhouse effect gas reduction amount are added together to find a total reduction amount of a greenhouse effect gas.

Preferably, the computer program causes the computer to execute

a procedure of finding a cost required in the case of securing the required heat quantity by the operation of the heating equipment and a cost required in the case of securing the required heat quantity by using the recovered heat individually, and finding an exhaust heat-use reduction cost from a difference between the costs, and

a procedure of finding a cost required in the case of providing the supply amount of the carbon dioxide using the fossil fuel and a cost required in the case of providing the supply amount of the carbon dioxide using the exhaust gas individually, and finding an exhaust gas-use reduction cost from a difference between the costs.

Preferably, the exhaust heat-use reduction cost and the exhaust gas-use reduction cost are added together to find a total reduction cost of energy.

Preferably, a periodic heat load during a predetermined cultivation period which is calculated using a daily nighttime heating load found in consideration of a floor area and a coverage area of the greenhouse, to a daily maximum air temperature and a daily minimum air temperature obtained from public weather data of an installation region of the greenhouse is calculated as the required heat quantity.

Preferably, the periodic heat load is found by adding a daily daytime heating load to the daily nighttime heating load.

Preferably, the daily daytime heating load is a value obtained by finding a "daytime indoor set temperature - outside air temperature - indoor solar heat effect temperature" for each predetermined time, and integrating only a positive value in an obtained value.

Preferably, the greenhouse effect gas emission amount in the case of providing the supply amount of the carbon dioxide using the device which generates carbon dioxide by the combustion of the fossil fuel as the carbon dioxide supply source and the greenhouse effect gas emission amount in the case of providing the supply amount of the carbon dioxide by using the carbon dioxide recovered from the exhaust gas are each found as a difference between the supply amount of the carbon dioxide and an absorption amount of carbon dioxide based on the plant.

Preferably, an amount of net photosynthesis of the plant is found as the absorption amount of the carbon dioxide based on the plant.

Preferably, the amount of net photosynthesis is found using a global solar irradiance amount, a light transmittance of the greenhouse, a light interception rate of a plant, and an indoor carbon dioxide concentration in the greenhouse.

Preferably, the indoor carbon dioxide concentration is calculated based on an indoor-outdoor ventilation rate of air in the greenhouse, and the ventilation rate is calculated using a difference between an outdoor specific enthalpy and an indoor specific enthalpy of the greenhouse.

Further, the present invention provides a computer-readable recording medium in which the above-described computer program is recorded. The recording medium in which the computer program is stored may be a non-transitory recording medium. The non-transitory recording medium is not particularly limited, and there are cited recording mediums such as a flexible disk, a hard disk, a CD-ROM, an MO (magneto-optical disk), a DVD-ROM, and a memory card, for example.

Effect of the Invention

According to the present invention, the exhaust heat-use greenhouse effect gas reduction amount in the case of using the recovered heat recovered from the exhaust heat for heating can be found, and the exhaust gas-use greenhouse effect gas reduction amount in the case of using the carbon dioxide recovered from the exhaust gas for growth promotion of plants can be found, and preferably, a total reduction amount of the greenhouse effect gas obtained by adding both together can be found. Further, a reduction cost of energy by using the exhaust heat and a reduction cost of energy by using the exhaust gas can be found, and preferably, a total reduction cost of energy obtained by adding both together can be found. Consequently, by comparison between the greenhouse effect gas reduction amount by recycling and using the recovered heat recovered from the exhaust heat and the carbon dioxide recovered from the exhaust gas obtained from various devices and facilities (including power stations, factories, and the like), and, that of the heating equipment operated by fossil fuels and the devices which generate carbon dioxide, a cost merit of energy in the case of using the exhaust heat and the exhaust gas can be estimated and grasped, which allows a contribution to the spread of resource-recycling greenhouse horticulture.

Brief Description of Drawings

[FIG. 1] FIG. 1 is a block diagram illustrating a schematic configuration of a resource-recycling greenhouse horticulture simulation apparatus according to one embodiment of the present invention.
[FIG. 2] FIG. 2 is a diagram illustrating one example of an input screen displayed on a display.
[FIG. 3] FIG. 3 is a diagram illustrating one example of an output screen displayed on the display.
[FIG. 4] FIG. 4 is a block diagram illustrating a schematic configuration of an exhaust heat-recycling simulation unit.
[FIG. 5] FIG. 5 is a diagram for explaining a calculation process of a periodic heat load in a required heat quantity calculation unit.
[FIG. 6] FIG. 6 is a diagram for explaining a calculation process of a nighttime degree hour.
[FIG. 7] FIG. 7 is a diagram for explaining a calculation process in a case of including a daily daytime heating load in the periodic heat load.
[FIG. 8] FIG. 8 is a diagram for explaining a calculation process of a greenhouse effect gas emission amount in a heating-origin greenhouse-effect-gas emission-amount calculation unit.
[FIG. 9] FIG. 9 is a block diagram illustrating a schematic configuration of an exhaust gas-recycling simulation unit.
[FIG. 10] FIG. 10 is a flowchart for explaining a calculation process of a daytime heat-release amount in an absorption amount calculation unit.
[FIG. 11] FIG. 11 is a flowchart for explaining a calculation process of an indoor carbon dioxide concentration in the absorption amount calculation unit.
[FIG. 12] FIG. 12 is a flowchart for explaining a calculation process of an amount of net photosynthesis and an absorption amount of carbon dioxide based on a plant in the absorption amount calculation unit.
[FIG. 13] FIG. 13 is a flowchart for explaining a calculation process of a supply amount of carbon dioxide.
[FIG. 14] FIG. 14 is a diagram for explaining a configuration of a total reduction amount calculation unit and a total reduction cost calculation unit.

Modes for Carrying out the Invention

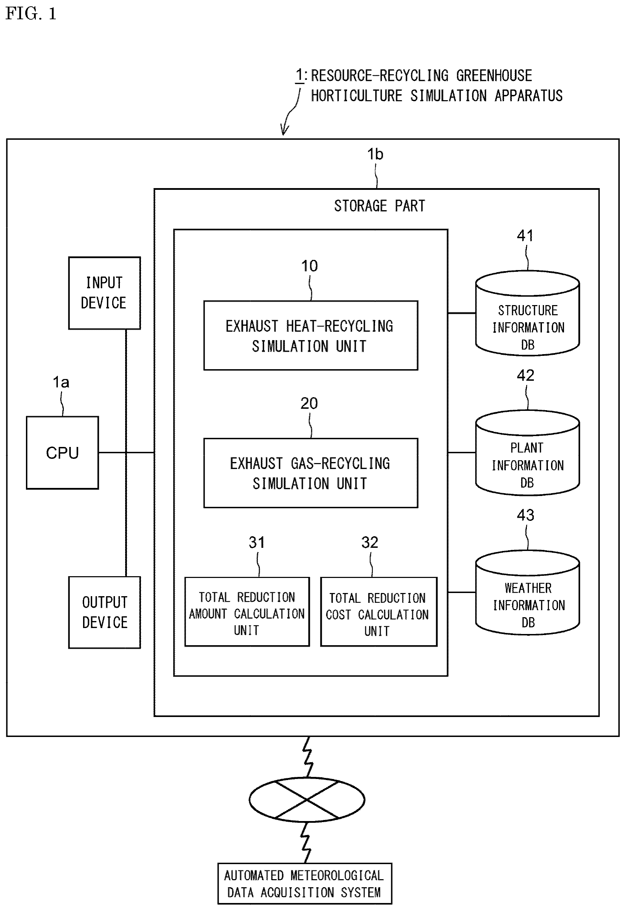

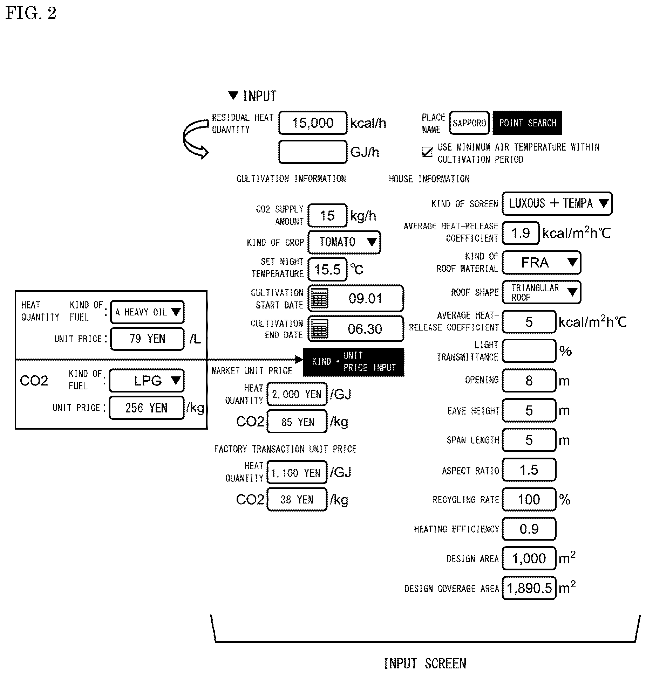

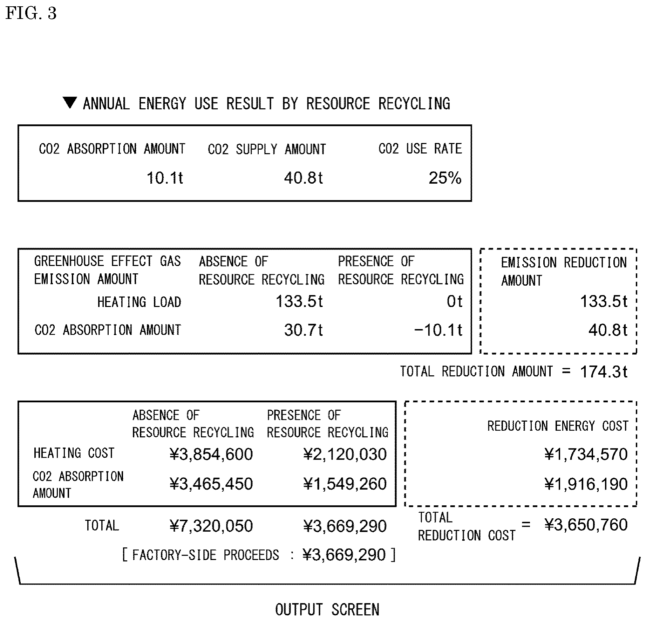

Hereinafter, based on an embodiment of the present invention illustrated in the drawings, description will be made in more detail. FIG. 1 is a diagram illustrating a schematic configuration of a resource-recycling greenhouse horticulture simulation apparatus 1 according to this embodiment. As illustrated in this diagram, the resource-recycling greenhouse horticulture simulation apparatus 1 of this embodiment is constituted of a computer (the kind of computer is not limited, and includes a personal computer, a microcomputer, a portable information terminal, and the like) including a processor (CPU) 1a and a storage part (a case of being referred to as "storage part" in this embodiment means including both of volatile and nonvolatile recording mediums such as main storage and storage, and neither of them is restrictive) 1b.
In the resource-recycling greenhouse horticulture simulation apparatus 1 of this embodiment, a computer program which executes procedures to cause the computer which is the resource-recycling greenhouse horticulture simulation apparatus 1 to function as an exhaust heat-recycling simulation unit 10 and an exhaust gas-recycling simulation unit 20 is stored in the storage part 1b. The computer program is normally stored in the nonvolatile recording medium such as a hard disk or an SSD which is built in or externally attached to the computer (resource-recycling greenhouse horticulture simulation apparatus 1), and is read and executed by the above-described processor 1a. Further, a storage location of various kinds of data may be a storage part connected via a communication line other than the storage part built in or externally attached to the resource-recycling greenhouse horticulture simulation apparatus 1. FIG. 2 illustrates an input screen for inputting necessary items using an input device of the resource-recycling greenhouse horticulture simulation apparatus 1, and FIG. 3 illustrates an output screen which outputs simulation results.

[Exhaust heat-recycling simulation]

The exhaust heat-recycling simulation unit 10 simulates a reduction amount of greenhouse effect gas in recovering exhaust heat to use it for heating and a reduction cost resulting therefrom, in a case of cultivating a predetermined plant in a greenhouse targeted for simulation. The greenhouse targeted for simulation may be an existing one in a predetermined region, or may be a greenhouse scheduled to be constructed in the predetermined region. As described later, at the time of simulation, a floor area and a coverage area of the greenhouse (as the term "coverage area" here, a total area, covered with a covering material, adding a side face, an end face, and, a ceiling face and a gable face forming a roof of the greenhouse together) are required, and when the greenhouse scheduled to be constructed is targeted, values of estimated floor area and coverage area are used (hereinafter, the floor area and the coverage area of the existing greenhouse and the estimated floor area and coverage area of the greenhouse scheduled to be constructed are collectively referred to as "design floor area" and "design coverage area"). Structure information regarding the greenhouse targeted for simulation, such as the design floor area, the design coverage area, and an average heat-release coefficient of a lining covering material, is stored in advance in a structure information database 42.

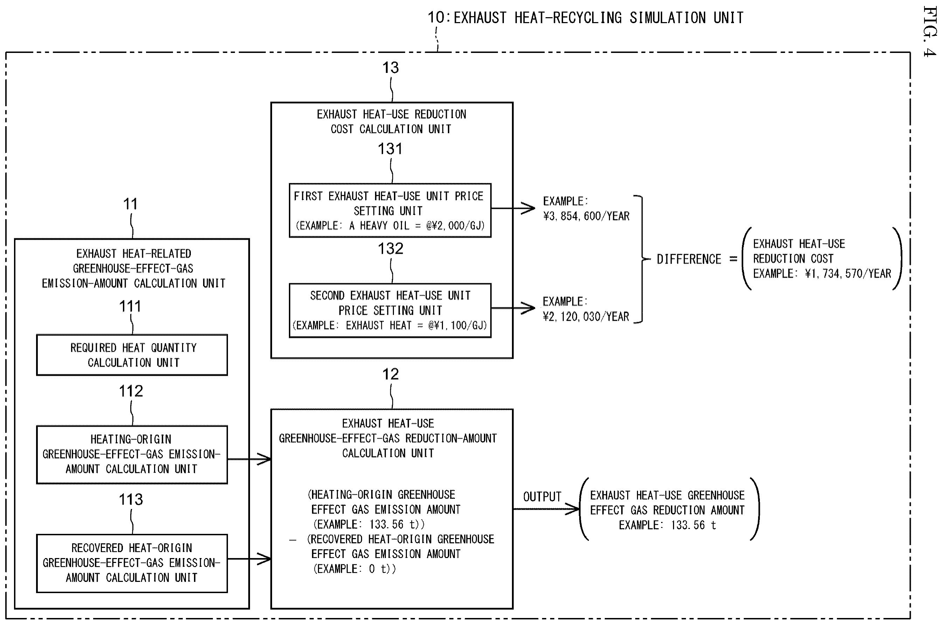

The exhaust heat-recycling simulation unit 10 has an exhaust heat-related greenhouse-effect-gas emission-amount calculation unit 11, an exhaust heat-use greenhouse-effect-gas reduction-amount calculation unit 12, and an exhaust heat-use reduction cost calculation unit 13, as illustrated in FIG. 4, and their functions are achieved by execution of the computer program. The exhaust heat-related greenhouse-effect-gas emission-amount calculation unit 11 finds a greenhouse effect gas emission amount in a case of securing a required heat quantity for securing a set night temperature suitable for a plant by using heating equipment operated by combustion of a fossil fuel, and finds a greenhouse effect gas emission amount in a case of securing the required heat quantity by using recovered heat recovered from the exhaust heat. Specifically, the exhaust heat-related greenhouse-effect-gas emission-amount calculation unit 11 executes procedures to cause it to function as a required heat quantity calculation unit 111, a heating-origin greenhouse-effect-gas emission-amount calculation unit 112, and a recovered heat-origin greenhouse-effect-gas emission-amount calculation unit 113.

[Calculation of required heat quantity]

The required heat quantity calculation unit 111 calculates the required heat quantity for securing the set night temperature in the greenhouse. The set night temperature is specified according to the kind of plant. A value corresponding to an average value during a cultivation period is adopted, and is preferably specified also in consideration of an installation region of the greenhouse, seasons, and the like. The set night temperature can also be set manually in the input screen illustrated in FIG. 2, and preferably, the resource-recycling greenhouse horticulture simulation apparatus 1 has a plant information database 42 which stores a proper night temperature (average value) for each kind of plant, and the required heat quantity calculation unit 111 is configured to gain access to the plant information database 42, and, read and set a night temperature (average value) corresponding to such a plant when the kind of plant targeted for cultivation is selected in the input screen. For example, in a case of tomato, a set night temperature = 15.5°C is read and set.

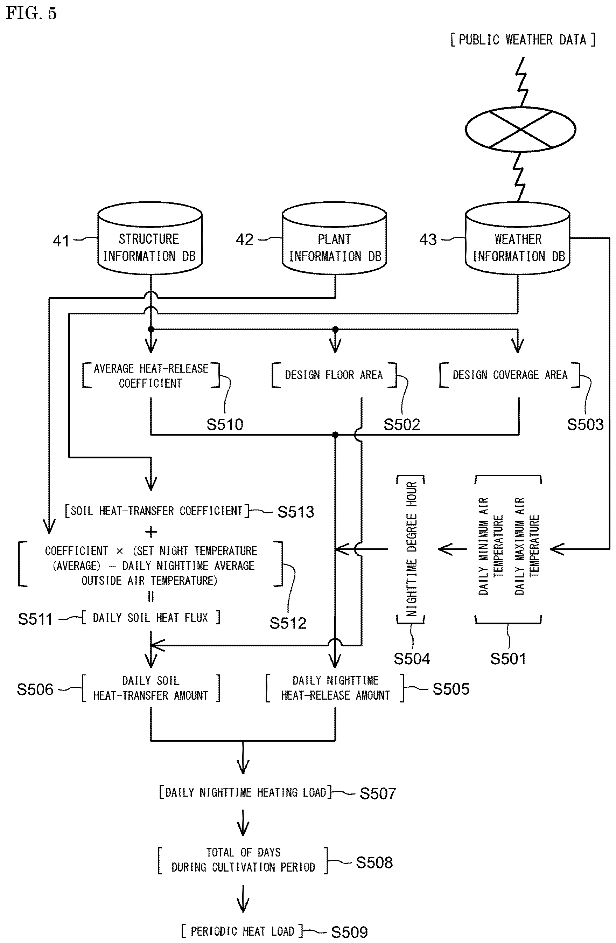

The required heat quantity calculation unit 111 finds a daily nighttime heating load (S507), in consideration of the design floor area (S502) and the design coverage area (S503) of the greenhouse, to a daily maximum air temperature and a daily minimum air temperature (S501) obtained from a weather information database 43 in which public weather data of the installation region of the greenhouse is stored, and finds a periodic heat load (S509) during the cultivation period using this daily nighttime heating load (S507), as illustrated in FIG. 5. This periodic heat load (S509) is the required heat quantity for securing the set night temperature during the cultivation period.

In order to find the daily nighttime heating load (S507), a daily nighttime heat-release amount (S505) and a daily soil heat-transfer amount (S506) are found. The daily nighttime heat-release amount (S505) is found by "design coverage area (S503) × average heat-release coefficient of lining covering material (roof material in a case where the lining covering material is not selected) (S510) × daily nighttime degree hour (S504)". Note that the design floor area, the design coverage area, and the average heat-release coefficient are read from the structure information database 41. Note that the "average heat-release coefficients" are values each obtained by finding an overnight heating load coefficient obtained by dividing an overnight heating heat quantity by an overnight nighttime degree hour corresponding thereto and a coverage area, regarding a plurality of kinds of films (the roof material, the lining covering material (curtain)) within an experimental period, to average them for each kind of films (the roof material, the lining covering material (curtain)). In this embodiment, there was adopted a value found by an experiment from November 9th, 1980 to February 3rd, 1981 conducted by providing four cultivation beds in each of three A to C houses constructed in Oyama Factory Farm Field of SEIWA CO., LTD. (a surface area: 262 $m^2$, a floor area: 120 $m^2$, an outer coating film: an agricultural vinyl chloride film, a heating system: a warm-air heater, a shape of curtain: A house ... a single layer of agricultural vinyl film, B, C houses ... double shaft and double layer, a curtain position (lower layer): A, B houses ... 1.8 m (from the ground), C house ... 1.85 m (from the ground), an interlayer distance in a case of double layer: 20 cm). In the experiment, only a portion on each cultivation bed was covered with a black mulch, and turnip greens, lettuce, field peas, and kidney beans were each planted for each cultivation bed, and an average value of the heating load coefficient in each house was found to correspond to the kind of films, and when the heating load coefficient of the A house was set to 100%, it was found what percent value was obtained according to combination of various films as the heating load coefficient of each of the B, C houses, and this value was set as the "average heat-release coefficient".

The daily nighttime degree hour (S504) is a value obtained by integrating a difference between the above-described set night temperature and an outside air temperature. For the nighttime degree hour, an approximate value is used. It is found in accordance with a calculation method of a geometrical heating degree hour when the daily maximum air temperature and the daily minimum air temperature in the region are connected with a straight line (refer to Journal of Agricultural Meteorology (J. Agr. Met.) 38 (1): pages 29-36, 1982, Makio HAYASHI, Toyoki KOZAI "Comparison of Actual and Calculated Heating Degree Hours and a Proposition of Heating Degree Hour Diagram").

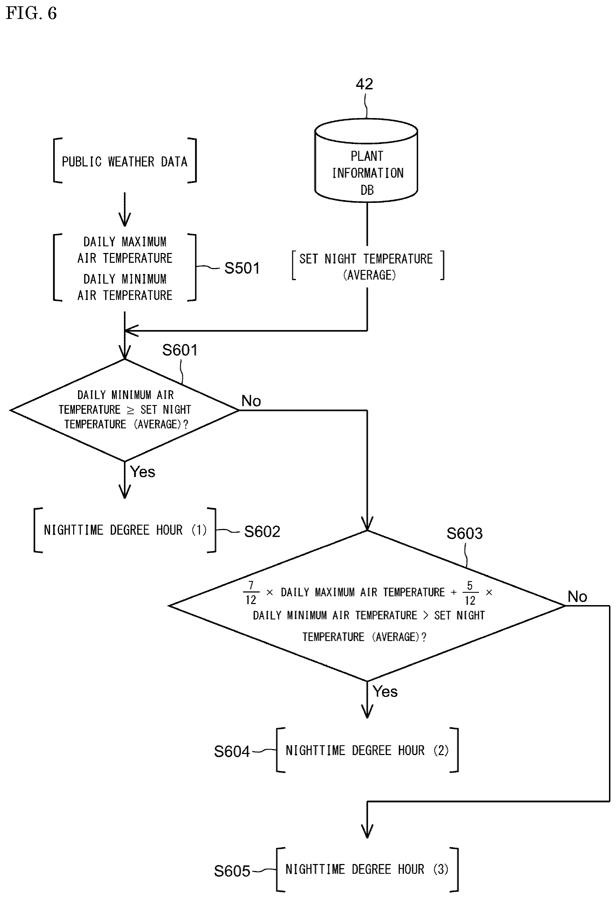

Specifically, as illustrated in FIG. 6, whether to be "daily minimum air temperature $\geq$ set night temperature" or not is determined (S601).

a) A case where the daily minimum air temperature is equal to or more than the set night temperature (a case of Yes in S601):
The nighttime degree hour is found by "(14 $\times$ set night temperature (average value) + (49 $\times$ daily maximum air temperature + 119 $\times$ daily minimum air temperature)/12) $\times$ 0". That is, in this case, there is no need for heating, and thus the nighttime degree hour (1) becomes 0 (S602).
b) Next, whether to be "7/12 $\times$ daily maximum air temperature + 5/12 $\times$ daily minimum air temperature > set night temperature (average value)" or not is determined (S603).

b-1) A case of exceeding the set night temperature (a case of Yes in S603):
By "12 $\times$ (set night temperature (average value) - daily minimum air temperature)2/(daily maximum air temperature - daily minimum air temperature)", the nighttime degree hour (2) is found (S604).
b-2) A case of being equal to or less than the set night temperature (a case of No in S603):
By "(14 $\times$ set night temperature (average value) + (49 $\times$ daily maximum air temperature + 119 $\times$ daily minimum air temperature)/12) $\times$ 1", the nighttime degree hour (3) is found (S605).

Note that it is more preferable in terms of accuracy to find the approximate value of the nighttime degree hour by using a machine learning model generated with the daily maximum air temperature and the daily minimum air temperature set as explanatory variables and with the nighttime degree hour set as an objective variable.

A daily soil heat-transfer amount (S506 in FIG. 5) is found by multiplying a daily soil heat flux (S511) by the design floor area (for example, 1000 m$^2$) (S502) and multiplying this by 14 hours corresponding to a night time from sunset to the following morning. The daily soil heat flux (S511) is found by multiplying a difference between the set night temperature (average value) and a daily nighttime average outside air temperature by a coefficient (S512) and adding the soil heat-transfer coefficient (in a case of Sapporo, -31) (S513) to this. The daily nighttime average outside air temperature is found, using the daily maximum air temperature and the daily minimum air temperature (S501) in the region, by "(5 $\times$ daily maximum air temperature + 19 $\times$ daily minimum air temperature)/24".

By adding the daily nighttime heat-release amount (S505) and the daily soil heat-transfer amount (S506) obtained in this manner together, the daily nighttime heating load (S507) is found. When a total of the daily nighttime heat-release amount (S505) and the daily soil heat-transfer amount (S506) is 0 or less, the daily nighttime heating load is calculated as 0.

The daily nighttime heating loads (S507) are found for the number of days corresponding to the cultivation period, and they are added together (S508). The periodic heat load is thus obtained (S509). Note that if the period is set for each month, a monthly periodic heat load is found, and if ones for 12 months are added together, an annual periodic heat load can be obtained.

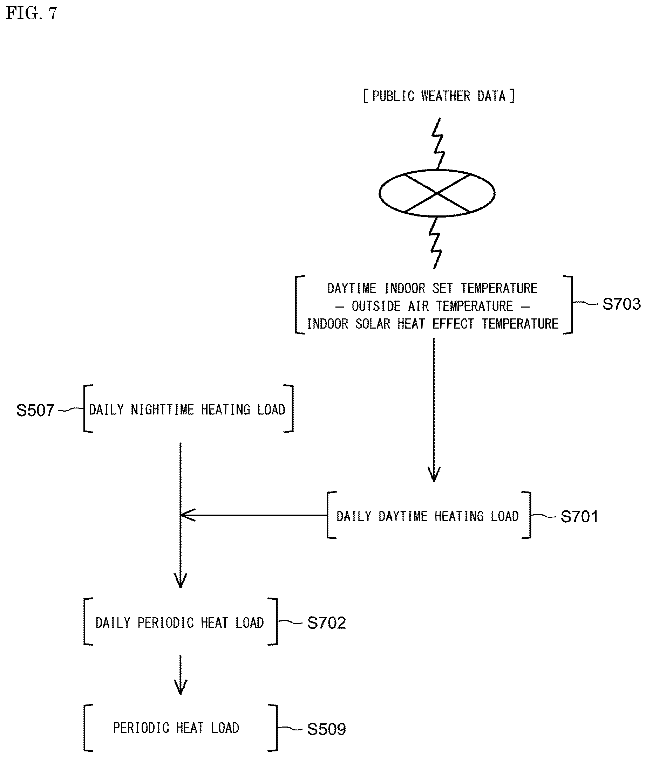

However, in finding the periodic heat load (S509), as illustrated in FIG. 7, not only the daily nighttime heating load (S507) but also a daily daytime heating load (S701) is added to find a daily periodic heat load (S702), and it is preferable to be configured to find the daily periodic heat loads for days corresponding to the cultivation period to add them together. The daily daytime heating load (S701) is a value in consideration of an effect of an amount of solar radiation. For the daily daytime heating load (S701), a fixed value can also be adopted simply, but it is preferable to refer to the public weather data, find a "daytime indoor set temperature - outside air temperature - indoor solar heat effect temperature" (S703), and find a value (degree hour) obtained by integrating only a positive part in it. Thus, by using the daily daytime heating load (S701), calculation accuracy of the periodic heat load (S509) increases. It is more preferable for the purpose of increasing the accuracy to find the daily daytime heating load (degree hour) (S701) by using a machine learning model generated with the daily maximum air temperature, the daily minimum air temperature, and sunshine hours set as explanatory variables.

Note that as described above, the required weather data such as the daily maximum air temperature and the daily minimum air temperature is stored in the weather information database 43 to match a region. The weather information database 43 can be formed by capturing the required information from Automated Meteorological Data Acquisition System (AMeDAS) or the like of the region. Note that without being limited to a case of reading these pieces of the information by access to the weather information database 43, it is also possible to use a scheme to read it by direct access to Automated Meteorological Data Acquisition System or the like of the region.

[Calculation of exhaust heat-use greenhouse effect gas reduction amount]

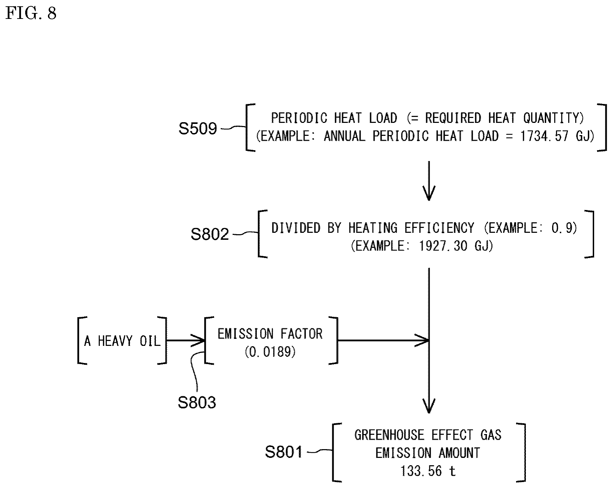

The heating-origin greenhouse-effect-gas emission-amount calculation unit 112 converts the required heat quantity for securing the set night temperature during the cultivation period, which is the periodic heat load (S509) found by the required heat quantity calculation unit 111, to a greenhouse effect gas emission amount. That is, the heating-origin greenhouse-effect-gas emission-amount calculation unit 112 finds a greenhouse effect gas emission amount (S801) in a case of securing the above-described required heat quantity by operation of the heating equipment, as illustrated in FIG. 8. The periodic heat load (S509) which is the required heat quantity may be made to correspond to the cultivation period, or may be found every month or every year as described above.

Here, the exhaust heat-use greenhouse-effect-gas reduction-amount calculation unit 12 of the exhaust heat-recycling simulation unit 10 calculates a greenhouse effect gas reduction amount by comparison between the greenhouse effect gas emission amount in the case of securing the required heat quantity for securing the set night temperature suitable for the plant by using the heating equipment operated by the combustion of fossil fuels and the greenhouse effect gas emission amount in the case of securing it by using the recovered heat recovered from the exhaust heat. Regarding the comparison, both calculation conditions are required to match each other, but when the recovered heat from the exhaust heat is used, an installation place of the greenhouse, and, a power station, a factory, or the like which is an exhaust heat source are normally separated by a predetermined distance. Accordingly, in the case of providing the above-described required heat quantity using the recovered heat from the exhaust heat, a heat quantity of the recovered heat is required to be a value exceeding the above-described required heat quantity, and in performing the simulation, the heat quantity of the recovered heat is found in consideration of an appropriate loss rate, to the above-described required heat quantity. When the loss rate is set to 10%, for example, the simulation is performed to have the above-described required heat quantity by multiplying the heat quantity of the recovered heat by the heating efficiency with the heating efficiency set to 90% in this embodiment. Thus, the greenhouse effect gas emission amount in the case of using the heating equipment by the combustion of fossil fuels is also found from a heat quantity in consideration of heating efficiency to the required heat quantity. However, strictly by reason of the simulation, a comparison only needs to become possible using the required heat quantity in the greenhouse, and the heating efficiency is not necessarily required to be considered, but considering the heating efficiency allows a value closer to an actual greenhouse effect gas emission amount to be found.

In this embodiment, an optional value can be input as the heating efficiency in the input screen in FIG. 2, and for example, a heating efficiency of 0.9 is assumed to be input. In this case, when the greenhouse effect gas emission amount in the case of securing the required heat quantity by the operation of the heating equipment is found, a value obtained by dividing the periodic heat load (S509) obtained in the above manner by the heating efficiency (for example, 0.9) is adopted (S802). For example, when an annual periodic heat load = 1734.57 GJ which is the required heat quantity is found by the required heat quantity calculation unit 111 (S509), this is divided by, for example, the heating efficiency = 0.9 to obtain 1927.30 GJ (S802). This value is multiplied by an emission factor (S803) linked according to the kind of fossil fuel. The kind of fossil fuel can be selected on the input screen, and as illustrated in FIG. 2, when an A heavy oil is selected, for example, a carbon dioxide emission factor = 0.0189 is adopted. Consequently, in this example, 1927.30 GJ $\times$ 0.0189 $\times$ 44/12 = 133.56 t is found. Then, the greenhouse effect gas emission amount = 133.5 t when the heating equipment is operated (when there is no resource recycling) is displayed on the output screen in FIG. 3.

The recovered heat-origin greenhouse-effect-gas emission-amount calculation unit 113 finds the greenhouse effect gas emission amount in the case of using the recovered heat from the exhaust heat. The recovered heat-origin greenhouse-effect-gas emission-amount calculation unit 113 calculates that the greenhouse effect gas emission amount derived from the recovered heat is 0 because a fuel consumption amount is 0 in the case of securing the required heat quantity by using the recovered heat. The output screen in FIG. 3 displays an emission amount of greenhouse effect gas = 0 t in the case of using the exhaust heat (case of the presence of resource recycling).

Note that when a case of failing to provide the required heat quantity with the recovered heat is considered, it is also possible to add a calculation program which calculates a greenhouse effect gas emission amount accompanied by compensating for a shortage of the heat quantity with the heating equipment. For example, when the power station, the factory, or the like which is the exhaust heat source partly stops operating during a predetermined period to cause a shortage of 20% of a heat quantity of a planned recovered heat, the shortage is provided by the operation of the heating equipment. In the above example, 385.46 GJ which is 20% of 1927.30 GJ is provided by the operation of the heating equipment. As a result, 385.46 GJ $\times$ 0.0189 $\times$ 44/12 = 26.71 t is the greenhouse effect gas emission amount caused by the operation of the heating equipment. The recovered heat-origin greenhouse-effect-gas emission-amount calculation unit 113 outputs 0 t + 26.71 t = 26.71 t as the greenhouse effect gas emission amount derived from the recovered heat in this case.

The exhaust heat-use greenhouse-effect-gas reduction-amount calculation unit 12 finds a difference between the greenhouse effect gas emission amount found by the heating-origin greenhouse-effect-gas emission-amount calculation unit 112 (heating-origin greenhouse effect gas emission amount) and the greenhouse effect gas emission amount found by the recovered heat-origin greenhouse-effect-gas emission-amount calculation unit 113 (recovered heat-origin greenhouse effect gas emission amount), and outputs the difference as the greenhouse effect gas reduction amount (exhaust heat-use greenhouse effect gas reduction amount). In a case of providing all the required heat quantity with the recovered heat, in the above example, 133.56 t - 0 t = 133.56 t is the exhaust heat-use greenhouse effect gas reduction amount, and is output as an emission reduction amount = 133.5 t in FIG. 3. Further, in a case of failing to provide all the required heat quantity with the recovered heat, as in the above example, in the case of providing 20% by using the heating equipment, 133.56 t - 26.71 t = 106.84 t is the exhaust heat-use greenhouse effect gas reduction amount.

[Calculation of exhaust heat-use reduction cost]

The exhaust heat-recycling simulation unit 10 further has the exhaust heat-use reduction cost calculation unit 13. The exhaust heat-use reduction cost calculation unit 13 finds a cost required in the case of securing the above-described required heat quantity by the operation of the heating equipment and a cost required in the case of securing the above-described required heat quantity by using the recovered heat individually, and finds an exhaust heat-use reduction cost from a difference between the costs.

The exhaust heat-use reduction cost calculation unit 13 has a first exhaust heat-use unit price setting unit 131 based on a market price of a fossil fuel and a second exhaust heat-use unit price setting unit 132 based on a transaction price of exhaust heat. These may be appropriately input from the input device on the input screen in FIG. 2, or may be captured from a database provided with market price data of fossil fuels and a database provided with transaction price data of exhaust heat.

First, in a cost required until securing the required heat quantity by the operation of the heating equipment, in a case of the A heavy oil, for example, when a unit price on a heat-quantity basis is set to ¥2000, the cost when the above-described 1927.30 GJ is provided, for example, is ¥2000 × 1927.30 GJ = ¥3,854,600.

On the other hand, when a factory transaction unit price of the exhaust heat which a greenhouse construction and management side purchases from an exhaust heat providing side is set to ¥1100/GJ in a unit price of the heat quantity, ¥1100 × 1927.30 GJ = ¥2,120,030 is obtained. Note that this amount of money is new proceeds based on exhaust heat which is only emitted into the air conventionally when seen from the factory or the like which is the exhaust heat providing side.

The exhaust heat-use reduction cost calculation unit 13 displays ¥3,854,600 and ¥2,120,030 on the output screen illustrated in FIG. 3. Then, a difference between the values is calculated. This difference of ¥1,734,570 is the exhaust heat-use reduction cost in the case of providing the required heat quantity with the recovered heat.

[Exhaust gas-recycling simulation]

The exhaust gas-recycling simulation unit 20 simulates a reduction amount of greenhouse effect gas in a case of supplying and providing carbon dioxide recovered from an exhaust gas into the greenhouse, and a reduction cost resulting therefrom.

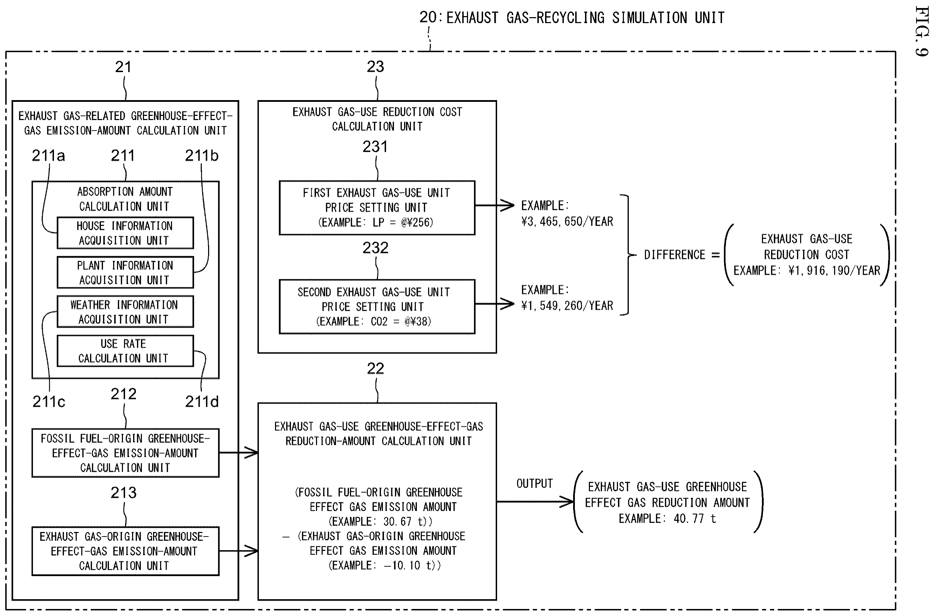

The exhaust gas-recycling simulation unit 20 has an exhaust gas-related greenhouse-effect-gas emission-amount calculation unit 21, an exhaust gas-use greenhouse-effect-gas reduction-amount calculation unit 22, and an exhaust gas-use reduction cost calculation unit 23, as illustrated in FIG. 9, and their functions are achieved by execution of the computer program.

The exhaust gas-related greenhouse-effect-gas emission-amount calculation unit 21 finds a difference between a supply amount of carbon dioxide and an absorption amount of carbon dioxide based on a plant cultivated in the greenhouse as a greenhouse effect gas emission amount, and the exhaust gas-use greenhouse-effect-gas reduction-amount calculation unit 22 finds a difference between a greenhouse effect gas emission amount in a case of providing the supply amount of carbon dioxide using a device which generates carbon dioxide by combustion of fossil fuels and a greenhouse effect gas emission amount in a case of providing the supply amount of carbon dioxide using the exhaust gas as an exhaust gas-use greenhouse effect gas reduction amount by using the carbon dioxide recovered from the exhaust gas.

Specifically, first, the exhaust gas-related greenhouse-effect-gas emission-amount calculation unit 21 executes procedures to cause it to function as an absorption amount calculation unit 211, a fossil fuel-origin greenhouse-effect-gas emission-amount calculation unit 212, and an exhaust gas-origin greenhouse-effect-gas emission-amount calculation unit 213.

The absorption amount calculation unit 211 finds an amount of net photosynthesis of the plant cultivated in the greenhouse as the absorption amount of carbon dioxide ($CO_2$) based on the plant. An amount of net photosynthesis P is an absorption amount of carbon dioxide actually absorbed by the plant, and can be found based on a global solar irradiance amount ($MJ/m^2$) ($I_o$), a light transmittance ($\tau$) of the covering material of the greenhouse, a light interception rate ($\phi$) of a plant, an indoor carbon dioxide concentration (indoor $CO_2$ concentration: $C_{in}$) of the greenhouse, a coefficient of transformation ($m^3/J$) ($\mu$) to a photosynthetic rate, a factor related to a reverse reaction ($\delta$). A global solar irradiance amount ($MJ/m^2$) ($I_o$) $\times$ light transmittance ($\tau$) of the covering material of the greenhouse is an incident solar heat quantity ($MJ/m^2$) of the greenhouse.

Specifically, the amount of net photosynthesis can be found using the following simultaneous equations (1) to (4).

(1) Merit and demerit of carbon dioxide (ventilation change amount of indoor-outdoor carbon dioxide (E))

$$E = V(C_{in} - C_{out})$$

(V: ventilation amount of air, $C_{out}$: carbon dioxide concentration in the air (a constant is available))

(2) An absorption amount of carbon dioxide (P)

$$P = I_o \cdot \tau \cdot \phi \cdot \mu \cdot C_{in}/(C_{out} + \delta)$$

(3) A supply amount of carbon dioxide (S)

$$S = P + E$$

(4) A heat balance equation

$$I_o \cdot \tau = k_{cover} \cdot 1/\beta \cdot (T_{in} - T_{out}) + V \cdot (H_{in} - H_{out}) \cdot \rho$$

($k_{cover}$: overall heat transfer coefficient of covering material, $\beta$: heat retention ratio (ratio of a floor area to a coverage area), $T_{in}$: indoor temperature, $T_{out}$: outdoor temperature, $H_{in}$: indoor specific enthalpy, $H_{out}$: outdoor specific enthalpy, $\rho$: air density)

The absorption amount calculation unit 211 includes a house information acquisition unit 211a, a plant information acquisition unit 211b, a weather information acquisition unit 211c, and a use rate calculation unit 211d.

The house information acquisition unit 211a acquires structure information of the greenhouse to be simulated. The structure information is the kind of roof material, the light transmittance and the average heat-release coefficient linked for each kind of roof material, the design floor area, the design coverage area, and the like, of the greenhouse. In this embodiment, as these pieces of the data, their actual data is used when a target for simulation is the existing greenhouse, and estimated data is used in the case of the greenhouse scheduled to be constructed. The structure information is stored in the structure information database 41 as described above, and the house information acquisition unit 211a gains access to the structure information database 41, and acquires the required information.

The plant information acquisition unit 211b acquires information of a plant targeted for cultivation. The information of the plant includes the light interception rate, a coefficient of transformation ($m^3/J$) to an amount of photosynthesis, and a ventilation temperature during the day (daytime ventilation temperature) suitable for cultivation of the plant which are specified for each kind of plant, and these pieces of the information are stored in the plant information database 42 for each kind of plant. Note that the "ventilation temperature" is a daytime control temperature proper for the plant targeted for cultivation, and is used in finding an estimated value of a later-described daytime indoor air temperature.

The weather information acquisition unit 211c acquires weather information of the installation region of the greenhouse. In the weather information, these pieces of the information including a daily daytime average air temperature, the daily maximum air temperature, the daily minimum air temperature, a daily total global solar irradiance amount, and a daily day length in the region are stored in the weather information database 43 to match the region as described above. However, it is as described above that a scheme to read it by direct access to Automated Meteorological Data Acquisition System or the like of the region can be used.

Note that a place name, the kind of plant, the kind of roof material of the greenhouse, the supply amount of carbon dioxide ($CO_2$), and the like are input using an appropriate input device, and displayed on the input screen of the display as illustrated in FIG. 2.

The use rate calculation unit 211d finds a rate of the absorption amount of carbon dioxide found by the above-described absorption amount calculation unit 211 to the supply amount of carbon dioxide supplied into the greenhouse from a carbon dioxide supply source during a predetermined period as a use rate. The supply amount of carbon dioxide is set by inputting an estimated supply amount from the carbon dioxide supply source on the input screen as described above. The absorption amount, the supply amount, and the use rate of carbon dioxide are output on the output screen in FIG. 3.

The carbon dioxide supply source corresponds to an exhaust gas generation source such as the power station, the substation, the factory, or the incineration plant when the exhaust gas is used, in addition to the device which generates carbon dioxide by the combustion of fossil fuels, such as a carbon dioxide generator.

[Calculation of carbon dioxide absorption amount]

The carbon dioxide absorption amount is the amount of net photosynthesis in this embodiment, and can be found using the above formulas (1) to (4). Hereinafter, one example of calculation steps of the carbon dioxide absorption amount using the above formulas (1) to (4) will be described.

(Acquisition of information)

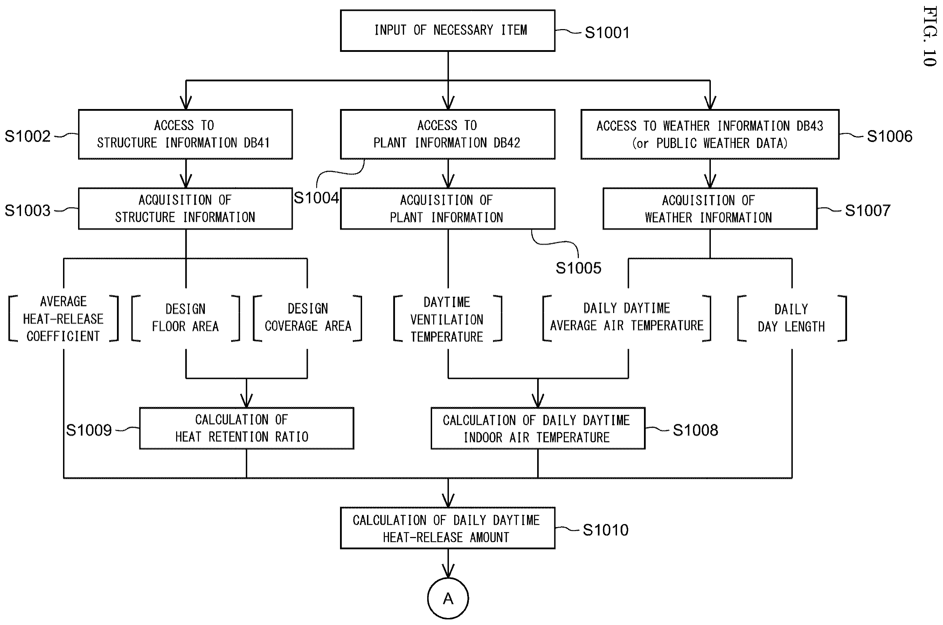

A simulation executor or the like inputs necessary items on the input screen illustrated in FIG. 2 from the input device (S1001 in FIG. 10). The input items are the place name (for example, Sapporo), the kind of plant (for example, tomato), and the kind of roof material (for example, an FRA). When these pieces of the information are input, the house information acquisition unit 211a gains access to the structure information database 41 (S1002), reads the average heat-release coefficient (for example, 5) corresponding to the kind of roof material, and acquires the design floor area (for example, 1000 $m^2$) and the design coverage area (for example, 1890.58 $m^2$) of the greenhouse in a predetermined size for simulation (S1003).

The plant information acquisition unit 211b gains access to the plant information database 42 (S1004), and acquires the daytime ventilation temperature determined for each plant, the daytime ventilation temperature (23°C) when the plant targeted for cultivation is "tomato" (S1005).

The weather information acquisition unit 211c gains access to the weather information database 43 (or from the public weather data or the like) (S1006), and acquires the daily daytime average air temperature (average outside air temperature found geometrically for each day using the daily maximum air temperature and the daily minimum air temperature obtained from weather data in the past year) and a daily day length (s) = 32400 s (a fixed value is adopted in this embodiment, and a value in consideration of latitude and seasons can also be used) of "Sapporo" (S1007).

Note that in the information acquired in the absorption amount calculation unit 211, the same information as information used in the required heat quantity calculation unit 111 is also present, and in this case, without newly gaining access to various databases, the information captured in the required heat quantity calculation unit 111 can be used as it is. Conversely, the information captured in the absorption amount calculation unit 21 can also be used in the required heat quantity calculation unit 111.

When these pieces of the information are acquired, the absorption amount calculation unit 211 further executes the following steps.

(Calculation of daytime heat-release amount)

First, a daily daytime indoor air temperature is found using the daily daytime average air temperature and the daytime ventilation temperature (23°C) (S1008). The daily daytime indoor air temperature can be found by a machine learning model which is an approximate expression found by regression analysis in which the daily daytime indoor air temperature is set as an objective variable and the daily daytime average air temperature and the daytime ventilation temperature (23°C) are set as explanatory variables. According to the approximate expression found in this embodiment, when the daily daytime average air temperature is less than 5°C, it is found by (daily ventilation temperature - 2), and when the daily daytime average air temperature is 5°C or more, it is found by (-0.8224 × daily daytime average air temperature + 1.299 × daytime ventilation temperature + 0.03229 × square of daily daytime average air temperature - 18.94/daily daytime average air temperature). A calculation is made as "21°C" using the former expression because this example is an example in which the daily daytime average air temperature is -0.7291°C (S1008).

Next, the heat retention ratio is found (S1009). The heat retention ratio is a design floor area/design coverage area, and is found as 1000/1890.58 = 0.5289 in the above-described example.

Next, a daily daytime heat-release amount (MJ/$m^2$) is found by the following formula (S1010).

The daily daytime heat-release amount (MJ/$m^2$) = (daily daytime indoor air temperature (°C) - daily daytime average air temperature (°C))/heat retention ratio × average heat-release coefficient of roof material × daily day length (s)/ 3600 × 4.186/1000 = 7.7384 (MJ/$m^2$)

(Calculation of daily solar heat balance)

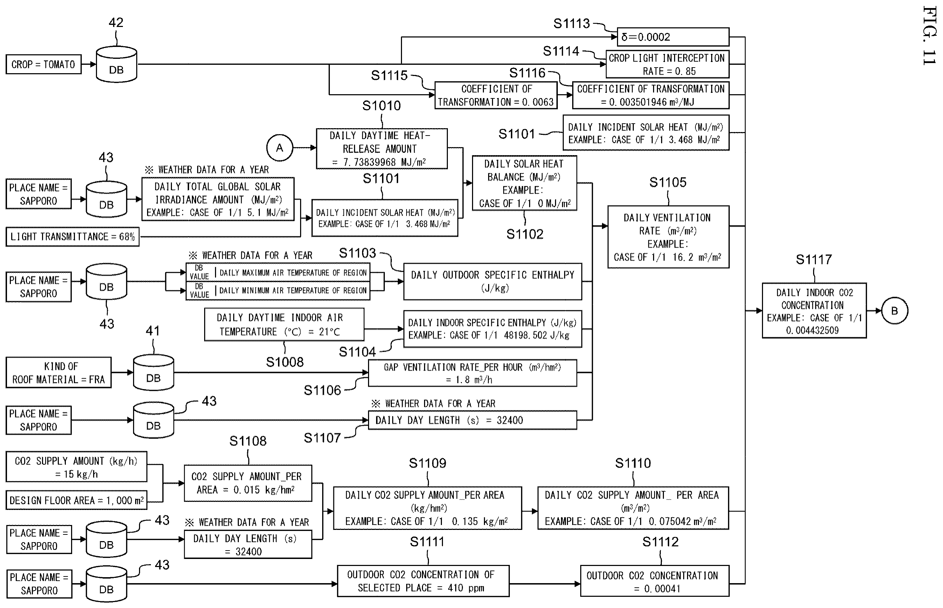

Next, a daily incident solar heat (MJ/m$^2$) is obtained by multiplying the daily total global solar irradiance amount (MJ/m$^2$) of "Sapporo" acquired from the weather information database 43, the public weather data, or the like (found from weather data for a year) and a light transmittance of the roof material acquired from the structure information database 41 together (S1101 in FIG. 11). A daily solar heat balance (MJ/m$^2$) is found as follows using this daily incident solar heat (MJ/m$^2$) and the daily daytime heat-release amount (MJ/m$^2$) found by S1010 in FIG. 10 (S1102).

In a case of daily daytime heat-release amount (MJ/m$^2$) > daily incident solar heat (MJ/m$^2$), a calculation is made as "0".

In a case of daily daytime heat-release amount (MJ/m$^2$) $\leq$ daily incident solar heat (MJ/m$^2$), it is found by "daily daytime heat-release amount (MJ/m$^2$) - daily incident solar heat (MJ/m$^2$)".

(Calculation of outdoor specific enthalpy)

Next, a daily outdoor specific enthalpy (J/kg) is found using the daily maximum air temperature and the daily minimum air temperature in the region acquired from the weather information database 43, the public weather data, or the like (S1103). The outdoor specific enthalpy is found using the following learned model.

First, from a daytime average air temperature and a daytime absolute humidity acquired from each of meteorological offices at a plurality of observation points, a daytime specific enthalpy is found by

$$H = 1.006 \cdot Td + (1.86) \cdot Td + 2501) \cdot x \text{ (Td is the air temperature, x is the absolute humidity).} \qquad \text{a general formula:}$$

The obtained specific enthalpy is set as an objective variable, and a maximum air temperature and a minimum air temperature are acquired for each day, and both are set as explanatory variables. This operation is performed one by one by obtaining their respective pieces of data for about two years from the meteorological offices at the above-described plurality of observation points, to generate the learned model by linear regression. As one example, the learned model used in this embodiment is indicated as follows.

The outdoor specific enthalpy (J/kg): $H = 4211 + 1389 \cdot T_h + 382.4 \cdot T_1 - 16.26 \cdot T_h^2 + 55.90T_1^2$ ($T_h$: daily maximum air temperature, $T_l$: daily minimum air temperature) (coefficient of determination = 0.9683)

The outdoor specific enthalpy is found using the daily maximum air temperature and the daily minimum air temperature in the region in this manner.

(Calculation of indoor specific enthalpy)

The indoor specific enthalpy (J/kg) is found using the daily daytime indoor air temperature found by S1008 in FIG. 10 (S1104). The indoor air temperature for finding the indoor specific enthalpy is found by generating the learned model by the linear regression using data of an actual greenhouse. Specifically, in a greenhouse operated by TOMATOPARK Co, Ltd. which is a company affiliated with the present applicant, the daytime indoor air temperature (objective variable), a day average outside air temperature (explanatory variable), and the ventilation temperature (explanatory variable) were measured for several tens of weeks, and the learned model was generated by the linear regression. Moreover, a relative humidity for finding x was set as a fixed value, and the indoor air temperature (Td) was divided into certain ranges to be regression-analyzed, resulting in generating the learned model in which the indoor specific enthalpy was set as an objective variable. As one example, the learned model used in this embodiment is indicated as follows.

The indoor specific enthalpy (J/kg): $H = 63.242Td^2 + 181.18Td + 16504$ (indoor air temperature Td = coefficient of determination in a range of 10 to 40°C = 0.9996)

(Calculation of ventilation rate)

Next, a daily ventilation rate (m$^3$/m$^2$) of indoor-outdoor air of the greenhouse is found (S1105). The daily ventilation rate is found using a gap ventilation rate per hour (m$^3$/hm$^2$) specified to correspond to the kind of roof material acquired from the structure information database 41 by the house information acquisition unit 211a (for example: 1.8 m$^3$/hm$^2$) and the above-described daily day length (s) linked to "Sapporo" (32400 s) in addition to the daily solar heat balance (MJ/m$^2$), the outdoor specific enthalpy (J/kg), and the indoor specific enthalpy (J/kg) which have been found based on the above (S1106, S1107).

Specifically, first,

A comparison is made between a value divided by a difference between the outdoor specific enthalpy (J/kg) and the indoor specific enthalpy (J/kg) (EA) = 1000000 $\times$ daily solar heat balance (MJ/m$^2$)/(outdoor specific enthalpy (J/kg) - indoor specific enthalpy (J/kg))/ 1.2 (density of air kg/m$^3$)

and

a value obtained by multiplying the gap ventilation rate (m$^3$/hm$^2$) and the daily day length (s) together (EB) = the daily ventilation rate (m$^3$/m$^2$) = gap ventilation rate (m$^3$/hm$^2$) $\times$ daily day length (s)/3600.

As a result of the comparison, in a case of EA < EB, the daily ventilation rate (m$^3$/m$^2$) = gap ventilation rate (m$^3$/hm$^2$) $\times$ daily day length (s)/3600 is adopted.

In a case of EA $\geq$ EB, the 1000000 $\times$ daily solar heat balance (MJ/m$^2$)/(outdoor specific enthalpy (J/kg) - indoor specific enthalpy (J/kg))/1.2 (density of air kg/m$^3$) is adopted.

(Calculation of indoor carbon dioxide concentration)

The absorption amount calculation unit 211 further finds a carbon dioxide supply amount per unit area from an input value of the carbon dioxide supply amount and the design floor area (S1108), and by multiplying this value by the daily day length (s) = 32400 s, finds a daily carbon dioxide supply amount per unit area (S1109). Note that when the carbon dioxide supply amount is in a unit of kg, it is found in terms of a unit of m$^3$ by being divided by a mass of carbon dioxide of 1 m$^3$ at 25°C at 1 atmospheric pressure (S1110). Further, the weather information acquisition unit 211c acquires an outdoor carbon dioxide concentration of "Sapporo" (410 ppm) from the weather information database 43 (S1111, S1112).

The plant information acquisition unit 211b of the absorption amount calculation unit 211 gains access to the plant information database 42 to acquire the factor related to the reverse reaction ($\delta$), the light interception rate ($\phi$), and the coefficient of transformation, regarding "tomato" (S1113 to S1115). A light interception amount (MJ) is converted to the amount of photosynthesis (m$^3$) by the coefficient of transformation (S1116).

When the above-described pieces of information are obtained, the absorption amount calculation unit 211 calculates a daily indoor carbon dioxide concentration according to the following formula using them (S1117).

The indoor carbon dioxide concentration = (-(light interception rate $\times$ daily incident solar heat $\times$ coefficient of transformation + daily ventilation rate $\times$ $\delta$ - daily carbon dioxide supply amount (per area) (m$^3$/m$^2$) - daily ventilation rate $\times$ indoor carbon dioxide concentration) + (square root of ((light interception rate $\times$ daily incident solar heat $\times$ coefficient of transformation + daily ventilation rate $\times$ $\delta$ - daily carbon dioxide supply amount (per area) (m$^3$/m$^2$) - daily ventilation rate $\times$ outdoor carbon dioxide concentration)$^2$ - 4 $\times$ daily ventilation rate $\times$ (-$\delta$ $\times$ daily carbon dioxide supply amount (per area) (m$^3$/m$^2$) - $\delta$ $\times$ daily ventilation rate $\times$ outdoor carbon dioxide concentration))/2/daily ventilation rate (m$^3$/m$^2$)

FIG. 11 illustrates one example of a calculation result obtained by applying numerical values concretely until finding the indoor carbon dioxide concentration with the absorption amount calculation unit 211. Thus, for example, an indoor carbon dioxide concentration = 0.004432509 is found.

(Calculation of daily amount of net photosynthesis)

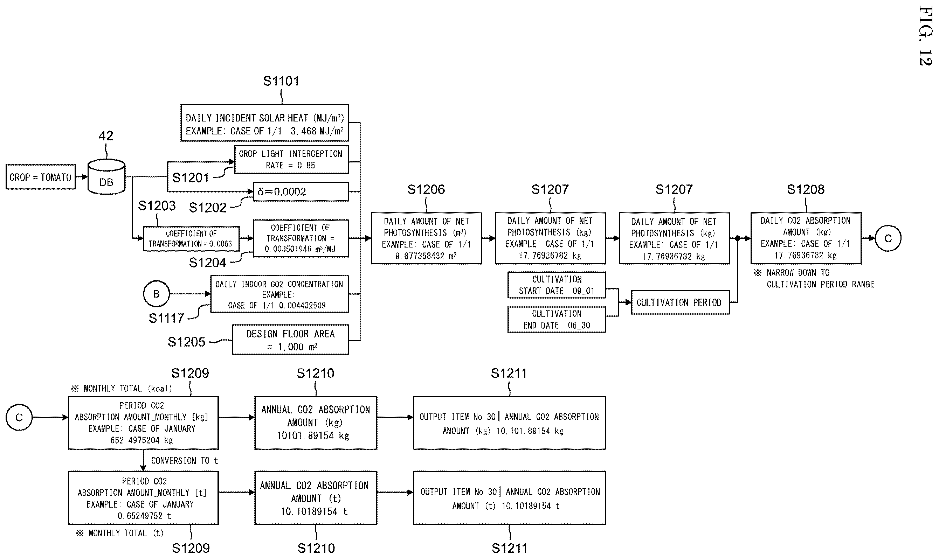

Access is gained to the plant information database 42 by the plant information acquisition unit 211b to acquire the factor related to the reverse reaction ($\delta$), the light interception rate ($\phi$), and the coefficient of transformation, regarding "tomato" (S1201 to S1203 in FIG. 12). A light interception amount (MJ) is converted to the amount of photosynthesis (m$^3$) by the coefficient of transformation (S1204).

Access is gained to the structure information database 41 by the house information acquisition unit 211a to acquire the design floor area (S1205).

A daily amount of net photosynthesis is found using the daily incident solar heat (MJ/m$^2$) (S1101) and the daily indoor carbon dioxide concentration (S1117) to these pieces of data (S1206).

In this embodiment, it is found by the following formula.

The daily amount of net photosynthesis ($m^3$) = daily incident solar heat ($MJ/m^2$) × light interception rate × coefficient of transformation ($m^3/J$) × daily indoor carbon dioxide concentration × design floor area/($\delta$ + daily indoor carbon dioxide concentration)

(Calculation of carbon dioxide absorption amount)

The obtained daily amount of net photosynthesis ($m^3$) is a daily carbon dioxide absorption amount, and is multiplied by a conversion factor to be converted to a unit of kg (S1207), and thereby the daily carbon dioxide absorption amount is found in a unit of kg (S1208).

By adding daily carbon dioxide absorption amounts during the cultivation period (for example, a cultivation start date September 1st, a cultivation end date: next June 1st) together, a period carbon dioxide absorption amount during the overall cultivation period is found. As a simulation, the period carbon dioxide absorption amount is found in a unit of month (S1209), and an annual carbon dioxide absorption amount can be found by integrating the ones for a year (S1210).

FIG. 12 illustrates one example of a calculation result of a process of calculating the carbon dioxide absorption amount with the absorption amount calculation unit 211. **In** this example, the daily amount of net photosynthesis = 9.877358432 $m^3$ = 17.76936782 kg, the daily carbon dioxide absorption amount = 17.76936782 kg, the period carbon dioxide absorption amount for a month (an example of integration from January 1st to January 31st during the above-described cultivation period) = 0.65249752 t, and the annual period carbon dioxide absorption amount = 10.10189154 t are found. The absorption amount calculation unit 211 outputs and displays "10.1 t" in a section of "$CO_2$ absorption amount" of the output screen illustrated in FIG. 3 (S1211).

[Calculation of use rate]

The use rate calculation unit 211d calculates a use rate using the carbon dioxide absorption amount obtained by the absorption amount calculation unit 211.

The use rate is found by a comparison with the carbon dioxide supply amount. The carbon dioxide supply amount is found as follows.

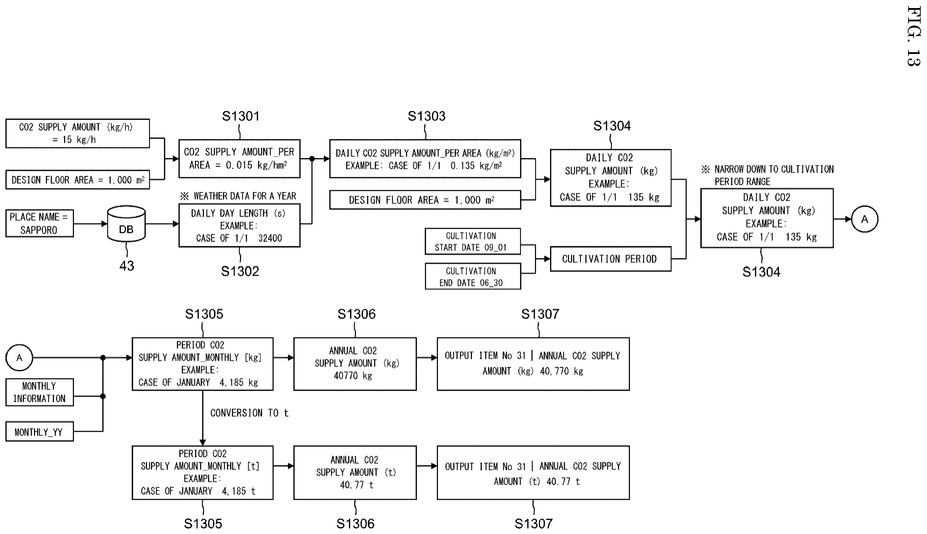

First, it is assumed that 15 kg/h is input as the carbon dioxide supply amount, for example (refer to the input screen in FIG. 2). This is divided by 1000 $m^2$ of the above-described design floor area to calculate an hourly supply amount per unit area of 0.015 $kg/hm^2$ (S1301 in FIG. 13). Next, the day length of "Sapporo" (32400 s) is read from the weather information database 43 (S1302) to find a daily hourly supply amount per unit area (S1303), and moreover, by being multiplied by 1000 $m^2$ of the design floor area, a daily carbon dioxide supply amount of 135 kg is found (S1304).

The daily carbon dioxide supply amount is found, and then the daily carbon dioxide supply amounts are integrated for an appropriate period, and similarly to the above-described carbon dioxide absorption amount, a period carbon dioxide supply amount is calculated in a unit of an actual cultivation period, a month, a year, or the like (S1305 to S1307). Thus, for example, a period carbon dioxide supply amount for a month of January = 4.185 t and an annual period carbon dioxide supply amount = 40.77 t are found. The use rate calculation unit 211d outputs and displays "40.8 t" in a section of "$CO_2$ supply amount" on the output screen illustrated in FIG. 3 (S1307).

The use rate calculation unit 211d calculates that the use rate is 10.10/40.77 = 24.8% in a case of a comparison by the year, and calculates that it is 0.652/4.185 = 15.6% in a case of a comparison with the one for a month of January, for example.

In an example of the output screen illustrated in FIG. 3, "$CO_2$ absorption amount: 10.1 t" is displayed as the annual carbon dioxide absorption amount, and "$CO_2$ supply amount: 40.8 t" is displayed as the annual carbon dioxide supply amount, and the use rate calculation unit 211d further outputs and displays an annual use rate as "25%" in a section of "$CO_2$ use rate".

The fossil fuel-origin greenhouse-effect-gas emission-amount calculation unit 212 has a function of finding the greenhouse effect gas emission amount (fossil fuel-origin greenhouse effect gas emission amount) in the case of providing the supply amount of carbon dioxide supplied into the greenhouse by using the device which generates carbon dioxide by the combustion of fossil fuels, and the exhaust gas-origin greenhouse-effect-gas emission-amount calculation unit 213 has a function of calculating the greenhouse effect gas emission amount (exhaust gas-origin greenhouse effect gas emission amount) in the case of providing the supply amount using carbon dioxide separated and recovered from the exhaust gas emitted from the exhaust gas generation source.

The fossil fuel-origin greenhouse effect gas emission amount corresponds to an amount excluding the absorption amount based on the plant in the supply amount into the greenhouse. The exhaust gas-origin greenhouse effect gas emission amount uses the exhaust gas, and thus an emission amount to the outdoors associated with ventilation is not an additional emission amount of carbon dioxide. As a result, the greenhouse effect gas emission amount decreases by the absorption caused by the plant, and the exhaust gas-origin greenhouse-effect-gas emission-amount calculation unit 213 calculates an amount corresponding to the absorption amount found by the absorption amount calculation unit 211 with a negative number, as the exhaust gas-origin greenhouse effect gas emission amount in a case of providing the entire amount in the supply amount into the greenhouse with the carbon dioxide separated and recovered from the exhaust gas (displayed as "-10.1 t" in the output screen in FIG. 3).

The exhaust gas-use greenhouse-effect-gas reduction-amount calculation unit 22 finds a difference between the fossil fuel-origin greenhouse effect gas emission amount found by the fossil fuel-origin greenhouse-effect-gas emission-amount calculation unit 212 and the fossil fuel-origin greenhouse effect gas emission amount found by the exhaust gas-origin greenhouse-effect-gas emission-amount calculation unit 213, as illustrated in FIG.9. At this time, since the exhaust gas-origin greenhouse effect gas emission amount is displayed with the negative number of the amount corresponding to the absorption amount in the case of providing the entire amount in the supply amount into the greenhouse with the carbon dioxide separated and recovered from the exhaust gas, the exhaust gas-use greenhouse-effect-gas reduction-amount calculation unit 22 outputs a value obtained by adding a value of an absolute value of the exhaust gas-origin greenhouse effect gas emission amount to a value of the fossil fuel-origin greenhouse effect gas emission amount, as a reduction amount. As a result, in the case of providing the entire amount of the carbon dioxide supply amount with the exhaust gas, the supply amount of carbon dioxide is the difference between the emission amounts, that is, the reduction amount, in comparison with the device using fossil fuels.

When the fossil fuel-origin greenhouse-effect-gas emission-amount calculation unit 212, the exhaust gas-origin greenhouse-effect-gas emission-amount calculation unit 213, and the exhaust gas-use greenhouse-effect-gas reduction-amount calculation unit 22 find the fossil fuel-origin greenhouse effect gas emission amount, the exhaust gas-origin greenhouse effect gas emission amount, and the exhaust gas-use greenhouse effect gas reduction amount, their respective values are output and displayed on the output screen illustrated in FIG. 3.

The exhaust gas-recycling simulation unit 20 further includes the exhaust gas-use reduction cost calculation unit 23. The exhaust gas-use reduction cost calculation unit 23 finds a cost required in the case of providing the supply amount of the carbon dioxide using the fossil fuel and a cost required in the case of providing the supply amount of the carbon dioxide using the exhaust gas individually, and finds an exhaust gas-use reduction cost from a difference between the costs, as illustrated in FIG. 9.

A carbon dioxide supply cost in the case of using the device which combusts a fossil fuel is found by a unit price of the fuel.

A mass unit price of carbon dioxide in the case of using the exhaust gas can be determined by an agreement among the parties in an enterprise of the exhaust gas generation source, a contractor of the greenhouse, administration, and the like. Further, it is also possible to refer to market prices of transactions of the carbon dioxide emission amount. Anyway, the carbon dioxide cost is set to be considerably more inexpensive than that in the case of using the fossil fuel.

The exhaust gas-use reduction cost calculation unit 23 has a first exhaust gas-use unit price setting unit 231 based on the market price of the fossil fuel and a second exhaust gas-use unit price setting unit 232 based on the transaction price of the exhaust gas. These may be appropriately input from the input device on the input screen in FIG. 2, or may be captured from the database provided with market price data of fossil fuels and a database provided with transaction price data of the exhaust gas.

Next, an example of simulating a reduction situation of the greenhouse effect gas by using the exhaust gas recycling-use simulation unit 20 will be described.

[Calculation of exhaust gas-use greenhouse effect gas reduction amount]

A difference between the greenhouse effect gas emission amount in the case of using the device which generates carbon dioxide by the combustion of the fossil fuel as the carbon dioxide supply source and the greenhouse effect gas emission amount in the case of using carbon dioxide from the exhaust gas generation source is calculated as the exhaust gas-use greenhouse effect gas reduction amount.

(The case of using the device which generates carbon dioxide by use of the fossil fuel)

In the fossil fuel-origin greenhouse-effect-gas emission-amount calculation unit 212, it is found by the following formula.

A fossil fuel-origin greenhouse effect gas emission amount = carbon dioxide supply amount - carbon dioxide absorption amount

In comparison by the year using the above-described example, the fossil fuel-origin greenhouse effect gas emission amount is found as

$$40.77 \, \text{t} - 10.10 \, \text{t} = 30.67 \, \text{t}.$$

(The case of providing the entire amount of the supply amount of carbon dioxide with the exhaust gas)

In the exhaust gas-origin greenhouse-effect-gas emission-amount calculation unit 213, it is found by the following formula.

An exhaust gas-origin greenhouse gas emission amount = -carbon dioxide absorption amount

In comparison by the year using the above-described example, the exhaust gas-origin greenhouse effect gas emission amount = -10.10 t is found.

(Exhaust gas-origin greenhouse effect gas reduction amount)

In the exhaust gas-origin greenhouse-effect-gas reduction-amount calculation unit 22, it is found by the following formula.

An exhaust gas-origin greenhouse effect gas reduction amount = fossil fuel-origin greenhouse effect gas emission amount - exhaust gas-origin greenhouse effect gas emission amount

In the above-described example, the exhaust gas-origin greenhouse effect gas reduction amount is found as

$$30.67 \, \text{t} - (-10.10 \, \text{t}) = 40.77 \, \text{t}.$$

Since this example is premised on providing the entire amount of the supply amount of carbon dioxide with the exhaust gas, the exhaust gas-origin greenhouse effect gas reduction amount which is the difference of the fossil fuel-origin greenhouse effect gas emission amount - the exhaust gas-origin greenhouse effect gas emission amount is equal to the supply amount of carbon dioxide, but for example, in a case of failing to obtain the supply of a sufficient exhaust gas from the factory or the like depending on times, the carbon dioxide generated by combusting the fossil fuel compensates for the shortage. In this case, for example, when it is assumed that the fossil fuel is used for a month in a year of the cultivation period and the exhaust gas is used for the other months, a period greenhouse effect gas reduction amount is calculated by the "carbon dioxide supply amount - carbon dioxide absorption amount" regarding the one for a month, and a negative number of a value corresponding to the carbon dioxide absorption amount is calculated as a period greenhouse effect gas emission amount regarding the other months, resulting in that a value obtained by integrating both is found as the exhaust gas-origin greenhouse effect gas emission amount.

For example, when the annual carbon dioxide supply amount is set to 40.77 t the same as the above, and the annual carbon dioxide absorption amount is set to 10.10 t the same as the above, the period greenhouse effect gas emission amount for a month when carbon dioxide is supplied using the fossil fuel is "3.5 - 2.1 = 1.4 t" assuming that a period carbon dioxide supply amount for a month is 3.5 t and a period carbon dioxide absorption amount for a month is 2.1 t. The period greenhouse effect gas emission amount (period carbon dioxide absorption amount) for the other eleven months when the exhaust gas is used is "10.10 - 2.1 = -8 t". Consequently, "-6.6 t" obtained by adding both together is the exhaust gas-origin greenhouse effect gas emission amount, and the greenhouse effect gas reduction amount is "30.67 - (-6.6) = 37.27 t".

Thus, as illustrated in FIG. 2, as input information, it is preferable that a rate of exhaust gas use in the carbon dioxide supply amount can be input as a recycling rate.

In this case, the absorption amount calculation unit 211 integrates the daily carbon dioxide absorption amounts excluding a period corresponding to this recycling rate, and the exhaust gas-origin greenhouse-effect-gas emission-amount calculation unit 213 can find the exhaust gas-origin greenhouse effect gas emission amount in accordance with the recycling rate by adding the period when the fossil fuel is used and the supply is performed and the period when the exhaust gas is used and supplied together, as described above.

On the output screen illustrated in FIG. 3, in a section displayed as "$CO_2$ absorption amount", by the fossil fuel-origin greenhouse-effect-gas emission-amount calculation unit 212, the exhaust gas-origin greenhouse-effect-gas emission-amount calculation unit 213, and the exhaust gas-origin greenhouse-effect-gas reduction-amount calculation unit 22, "30.7 t" is output as an annual greenhouse effect gas emission amount in the case of using the device which generates carbon dioxide by use of the fossil fuel (the absence of resource recycling), and "-10.1 t" which is a negative number of a value corresponding to the annual carbon dioxide absorption amount is output as an annual greenhouse effect gas emission amount in the case of using the exhaust gas at a recycling rate of 100% (the presence of resource recycling), and "40.8 t" is output and displayed as the exhaust gas-origin greenhouse effect gas reduction amount, respectively.

[Calculation of reduction cost of carbon dioxide supply cost]

(The case of using the device which generates carbon dioxide by use of the fossil fuel)

The exhaust gas-use reduction cost calculation unit 23 makes a calculation using a unit price set by the first exhaust gas-use unit price setting unit 231 based on the market price of the fossil fuel. For example, in a case of a device using an LPG as the fuel, when a fuel unit price of the LPG is set to ¥256/kg, according to a heating value of 50.08 MJ/kg and a carbon emission factor; 0.01637 kgC/kg, a mass unit price of carbon dioxide is

$$256/(0.01637 \times 50.08 \times 44/12) = ¥85.$$

When the supply amount of carbon dioxide is set to the period carbon dioxide supply amount for a month of January = 4.185 t and the annual period carbon dioxide supply amount = 40.77 t according to the above-described example, a calculation is made as follows.

$$\text{A monthly carbon dioxide supply cost of January} = ¥85 \times 4185 \text{ kg} = ¥355,725$$

$$\text{An annual carbon dioxide supply cost} = ¥85 \times 40770 \text{ kg} = ¥3,465,450$$

(The case of providing the entire amount of the supply amount of carbon dioxide with the exhaust gas)

Assuming that the mass unit price of carbon dioxide is ¥38 in a transaction price of the exhaust gas set by the second exhaust gas-use unit price setting unit 232, a calculation is made similarly to the above.

$$\text{The monthly carbon dioxide supply cost of January} = ¥38 \times 4185 \text{ kg} = ¥159,030$$

$$\text{The annual carbon dioxide supply cost} = ¥38 \times 40770 \text{ kg} = ¥1,549,260$$

(Reduction cost of carbon dioxide supply cost)

$$\text{A monthly carbon dioxide reduction cost of January} = ¥355,725 - ¥159,030 = ¥196,695$$

$$\text{An annual carbon dioxide reduction cost} = ¥3,465,450 - ¥1,549,260 = ¥1,916,190$$

Note that in a case of setting the recycling rate, the supply cost of carbon dioxide and the reduction cost of the carbon dioxide supply cost are calculated according to the recycling rate, similarly to the case of finding the above-described exhaust gas-origin greenhouse effect gas emission amount and exhaust gas-origin greenhouse effect gas reduction amount.

On the output screen illustrated in FIG. 3, in a section displayed as "$CO_2$ cost", by the exhaust gas-use reduction cost calculation unit 23, "¥3,465,450" is output as an annual carbon dioxide supply cost in the case of using the device which generates carbon dioxide by the use of the fossil fuel (the absence of resource recycling), "¥1,549,260" is output as an annual carbon dioxide supply cost in the case of using the exhaust gas at a recycling rate of 100% (the presence of resource recycling), and "¥1,916,190" is output and displayed as the reduction cost. Note that "¥1,549,260" which is an example of the annual carbon dioxide supply cost in the case of "the presence of resource recycling" is new proceeds based on the exhaust gas which is only emitted into the air conventionally when seen from the factory or the like which is the exhaust gas providing side.

[Calculation of total reduction amount of greenhouse effect gas and total reduction cost of energy]

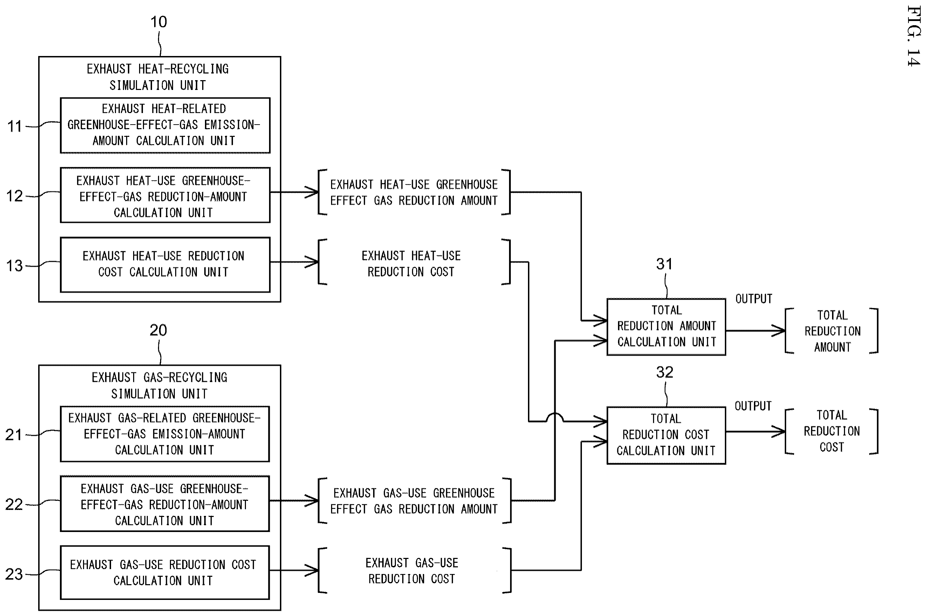

In this embodiment, as illustrated in FIG. 9 and FIG. 14, the resource-recycling greenhouse horticulture simulation apparatus 1 further includes a total reduction amount calculation unit 31 and a total reduction cost calculation unit 32 which calculate a total reduction amount of greenhouse effect gas and a total reduction cost of energy which are obtained by the exhaust heat-recycling simulation unit 10 and the exhaust gas-recycling simulation unit 20 respectively. These also function as the total reduction amount calculation unit 31 and the total reduction cost calculation unit 32 in the resource-recycling greenhouse horticulture simulation apparatus 1 according to this embodiment by the execution of the computer program.

The total reduction amount calculation unit 31 adds the exhaust heat-use greenhouse effect gas reduction amount obtained by the exhaust heat-use greenhouse-effect-gas emission-amount calculation unit 12 and the exhaust gas-use greenhouse effect gas reduction amount obtained by the exhaust gas-use greenhouse-effect-gas reduction-amount calculation unit 22 together to find the total reduction amount of the greenhouse effect gas. In the above-described example, "133.5 t + 40.8 t = 174.3 t" is the total reduction amount of the greenhouse effect gas, and is displayed on the output screen in FIG. 3.

The total reduction cost calculation unit 32 adds the exhaust heat-use reduction cost obtained by the exhaust heat-use reduction cost calculation unit 13 and the exhaust gas-use reduction cost obtained by the exhaust gas-use reduction cost calculation unit 23 together to find the total reduction cost of energy. In the above-described example, "¥1,734,570 + ¥1,916,190 = ¥3,650,760" is the total reduction cost of the energy, and is displayed on the output screen in FIG. 3.

According to this embodiment, in the greenhouse in a predetermined size, in the case of cultivating a predetermined plant during a predetermined period, it is possible to compare the case of performing the heating and the supply of carbon dioxide using fossil fuels and the case of providing the supply of the required heat quantity and carbon dioxide using the exhaust heat and the exhaust gas, and simulate the reduction amount of greenhouse effect gas and the reduction cost of energy. Accordingly, it is possible to estimate and grasp the reduction of greenhouse effect gas and the cost merit in the case of using the exhaust heat and the exhaust gas, which promotes a new construction of the greenhouse using the exhaust heat and the exhaust gas, and also in the factory or the like providing the exhaust heat and the exhaust gas, their effective use and profits are made clearer. As a result, it is possible to contribute to the spread of resource-recycling greenhouse horticulture.

Further, the annual heating cost: ¥2,120,030 and the annual carbon dioxide supply cost: ¥1,549,260 in the case of "the presence of resource recycling" are new proceeds based on exhaust gas which is only emitted into the air conventionally when seen from the factory or the like which is the exhaust gas providing side, as described above. Accordingly, as illustrated in FIG. 3, in the output screen, an item displaying this amount of money as gross proceeds in the exhaust gas providing side is preferably provided. In this example, this allows the total amount of ¥3,669,290 to be grasped as the new proceeds of the factory or the like which is the exhaust gas providing side, which results in an incentive for the exhaust gas providing side to be in cooperation with the greenhouse.

Explanation of Reference Signs

1 resource-recycling greenhouse horticulture simulation apparatus

10 exhaust heat-recycling simulation unit

11 exhaust heat-related greenhouse-effect-gas emission-amount calculation unit

111 required heat quantity calculation unit

112 heating-origin greenhouse-effect-gas emission-amount calculation unit

113 recovered heat-origin greenhouse-effect-gas emission-amount calculation unit

12 exhaust heat-use greenhouse-effect-gas reduction-amount calculation unit

13 exhaust heat-use reduction cost calculation unit

20 exhaust gas-recycling simulation unit

21 exhaust gas-related greenhouse-effect-gas emission-amount calculation unit

211 absorption amount calculation unit

212 fossil fuel-origin greenhouse-effect-gas emission-amount calculation unit

213 exhaust gas-origin greenhouse-effect-gas emission-amount calculation unit

22 exhaust gas-use greenhouse-effect-gas reduction-amount calculation unit

23 exhaust gas-use reduction cost calculation unit

31 total reduction amount calculation unit

32 total reduction cost calculation unit

41 structure information database

42 plant information database

43 weather information database


**Claims**

1.  A resource-recycling greenhouse horticulture simulation apparatus comprising:

    in a case of cultivating a predetermined plant in a greenhouse, an exhaust heat-recycling simulation unit in a case of recovering exhaust heat to use the exhaust heat for heating;
    and an exhaust gas-recycling simulation unit in a case of using carbon dioxide obtained by recovering an exhaust gas for growth promotion of the plant, wherein:

    the exhaust heat-recycling simulation unit comprises:

    an exhaust heat-related greenhouse-effect-gas emission-amount calculation unit which finds a greenhouse effect gas emission amount in a case of securing a required heat quantity for keeping a set night temperature suitable for the plant by using heating equipment operated by combustion of a fossil fuel, and finds a greenhouse effect gas emission amount in a case of securing the required heat quantity by using recovered heat recovered from the exhaust heat; and
    an exhaust heat-use greenhouse-effect-gas reduction-amount calculation unit which finds a difference between the greenhouse effect gas emission amount in the case of securing the required heat quantity by using the heating equipment and the greenhouse effect gas emission amount in the case of securing the required heat quantity by using the recovered heat recovered from the exhaust heat as an exhaust heat-use greenhouse effect gas reduction amount by using the recovered heat; and

    the exhaust gas-recycling simulation unit comprises:

    an exhaust gas-related greenhouse-effect-gas emission-amount calculation unit which finds a greenhouse effect gas emission amount in a case of providing a supply amount of carbon dioxide supplied into the greenhouse by using a device which generates carbon dioxide by combustion of a fossil fuel as a carbon dioxide supply source, and finds a greenhouse effect gas emission amount in a case of providing the supply amount of the carbon dioxide by using carbon dioxide recovered from the exhaust gas; and

an exhaust gas-use greenhouse-effect-gas reduction-amount calculation unit which finds a difference between the greenhouse effect gas emission amount in the case of providing the supply amount of the carbon dioxide using the fossil fuel and the greenhouse effect gas emission amount in the case of providing the supply amount of the carbon dioxide using the exhaust gas as an exhaust gas-use greenhouse effect gas reduction amount by using the carbon dioxide recovered from the exhaust gas.

2. The resource-recycling greenhouse horticulture simulation apparatus according to claim 1, comprising a total reduction amount calculation unit which adds the exhaust heat-use greenhouse effect gas reduction amount obtained by the exhaust heat-use greenhouse-effect-gas emission-amount calculation unit and the exhaust gas-use greenhouse effect gas reduction amount obtained by the exhaust gas-use greenhouse-effect-gas reduction-amount calculation unit together to find a total reduction amount of a greenhouse effect gas.

3. The resource-recycling greenhouse horticulture simulation apparatus according to claim 1, wherein:

the exhaust heat-recycling simulation unit comprises an exhaust heat-use reduction cost calculation unit which finds a cost required in the case of securing the required heat quantity by the operation of the heating equipment and a cost required in the case of securing the required heat quantity by using the recovered heat individually, and finds an exhaust heat-use reduction cost from a difference between the costs; and
the exhaust gas-recycling simulation unit comprises an exhaust gas-use reduction cost calculation unit which finds a cost required in the case of providing the supply amount of the carbon dioxide using the fossil fuel and a cost required in the case of providing the supply amount of the carbon dioxide using the exhaust gas individually, and finds an exhaust gas-use reduction cost from a difference between the costs.

4. The resource-recycling greenhouse horticulture simulation apparatus according to claim 3, comprising a total reduction cost calculation unit which adds the exhaust heat-use reduction cost obtained by the exhaust heat-use reduction cost calculation unit and the exhaust gas-use reduction cost obtained by the exhaust gas-use reduction cost calculation unit together to find a total reduction cost of energy.

5. The resource-recycling greenhouse horticulture simulation apparatus according to claim 1, wherein:

the exhaust heat-recycling simulation unit comprises a required heat quantity calculation unit for calculating the required heat quantity used in the exhaust gas-related greenhouse-effect-gas emission-amount calculation unit; and
the required heat quantity calculation unit is a means of calculating, as the required heat quantity, a periodic heat load during a predetermined cultivation period which is calculated using a daily nighttime heating load found in consideration of a floor area and a coverage area of the greenhouse, to a daily maximum air temperature and a daily minimum air temperature obtained from public weather data of an installation region of the greenhouse.

6. The resource-recycling greenhouse horticulture simulation apparatus according to claim 5, wherein the periodic heat load is found by adding a daily daytime heating load to the daily nighttime heating load.

7. The resource-recycling greenhouse horticulture simulation apparatus according to claim 6, wherein the daily daytime heating load is a value obtained by finding a "daytime indoor set temperature - outside air temperature - indoor solar heat effect temperature" for each predetermined time, and integrating only a positive value in an obtained value.

8. The resource-recycling greenhouse horticulture simulation apparatus according to claim 1, wherein

the exhaust gas-related greenhouse-effect-gas emission-amount calculation unit is a means of finding a difference between the supply amount of the carbon dioxide and an absorption amount of carbon dioxide based on the plant as the greenhouse effect gas emission amount.

9. The resource-recycling greenhouse horticulture simulation apparatus according to claim 8, wherein:

the exhaust gas-recycling simulation unit comprises an absorption amount calculation unit which calculates the absorption amount of the carbon dioxide used in the exhaust gas-related greenhouse-effect-gas emission-amount calculation unit; and
the absorption amount calculation unit is
a means of finding an amount of net photosynthesis of the plant as the absorption amount of the carbon dioxide based on the plant.

10. The resource-recycling greenhouse horticulture simulation apparatus according to claim 9, wherein
the absorption amount calculation unit finds the amount of net photosynthesis using a global solar irradiance amount, a light transmittance of the greenhouse, a light interception rate of a plant, and an indoor carbon dioxide concentration in the greenhouse.

11. The resource-recycling greenhouse horticulture simulation apparatus according to claim 10, wherein:

the indoor carbon dioxide concentration is calculated based on an indoor-outdoor ventilation rate of air in the greenhouse; and
the ventilation rate is calculated using a difference between an outdoor specific enthalpy and an indoor specific enthalpy of the greenhouse.

12. A computer program which causes a computer to function as a resource-recycling greenhouse horticulture simulation apparatus, the computer program causing the computer to execute, by

finding a greenhouse effect gas emission amount in a case of securing a required heat quantity for keeping a set night temperature suitable for a plant cultivated in a greenhouse by using heating equipment operated by combustion of a fossil fuel, and finding a greenhouse effect gas emission amount in a case of securing the required heat quantity by using recovered heat recovered from exhaust heat, and
finding a difference between the greenhouse effect gas emission amount in the case of securing the required heat quantity by using the heating equipment and the greenhouse effect gas emission amount in the case of securing the required heat quantity by using the recovered heat recovered from the exhaust heat as an exhaust heat-use greenhouse effect gas reduction amount by using the recovered heat,
an exhaust heat recycling-use simulation in a case of using the recovered heat recovered from the exhaust heat for heating, and
the computer program causing the computer to execute, by
finding a greenhouse effect gas emission amount in a case of providing a supply amount of carbon dioxide supplied into the greenhouse by using a device which generates carbon dioxide by combustion of a fossil fuel as a carbon dioxide supply source, and finding a greenhouse effect gas emission amount in a case of providing the supply amount of the carbon dioxide by using carbon dioxide recovered from an exhaust gas, and
finding a difference between the greenhouse effect gas emission amount in the case of providing the supply amount of the carbon dioxide using the fossil fuel and the greenhouse effect gas emission amount in the case of providing the supply amount of the carbon dioxide using the exhaust gas as an exhaust gas-use greenhouse effect gas reduction amount by using the carbon dioxide recovered from the exhaust gas,
an exhaust gas recycling-use simulation in a case of using the carbon dioxide recovered from the exhaust gas for growth promotion of the plant.

13. The computer program according to claim 12, wherein
the exhaust heat-use greenhouse effect gas reduction amount and the exhaust gas-use greenhouse effect gas reduction amount are added together to find a total reduction amount of a greenhouse effect gas.

14. The computer program according to claim 12, causing the computer to execute

a procedure of finding a cost required in the case of securing the required heat quantity by the operation of the heating equipment and a cost required in the case of securing the required heat quantity by using the recovered heat individually, and finding an exhaust heat-use reduction cost from a difference between the costs, and
a procedure of finding a cost required in the case of providing the supply amount of the carbon dioxide using the fossil fuel and a cost required in the case of providing the supply amount of the carbon dioxide using the exhaust gas individually, and finding an exhaust gas-use reduction cost from a difference between the costs.

15. The computer program according to claim 14, wherein
the exhaust heat-use reduction cost and the exhaust gas-use reduction cost are added together to find a total reduction cost of energy.

**16.** The computer program according to claim 12, wherein
a periodic heat load during a predetermined cultivation period which is calculated using a daily nighttime heating load found in consideration of a floor area and a coverage area of the greenhouse, to a daily maximum air temperature and a daily minimum air temperature obtained from public weather data of an installation region of the greenhouse is calculated as the required heat quantity.

**17.** The computer program according to claim 16, wherein
the periodic heat load is found by adding a daily daytime heating load to the daily nighttime heating load.

**18.** The computer program according to claim 17, wherein
the daily daytime heating load is a value obtained by finding a "daytime indoor set temperature - outside air temperature - indoor solar heat effect temperature" for each predetermined time, and integrating only a positive value in an obtained value.

**19.** The computer program according to claim 12, wherein
the greenhouse effect gas emission amount in the case of providing the supply amount of the carbon dioxide using the device which generates carbon dioxide by the combustion of the fossil fuel as the carbon dioxide supply source and the greenhouse effect gas emission amount in the case of providing the supply amount of the carbon dioxide by using the carbon dioxide recovered from the exhaust gas are each found as a difference between the supply amount of the carbon dioxide and an absorption amount of carbon dioxide based on the plant.

**20.** The computer program according to claim 19, wherein
an amount of net photosynthesis of the plant is found as the absorption amount of the carbon dioxide based on the plant.

**21.** The computer program according to claim 20, wherein
the amount of net photosynthesis is found using a global solar irradiance amount, a light transmittance of the greenhouse, a light interception rate of a plant, and an indoor carbon dioxide concentration in the greenhouse.

**22.** The computer program according to claim 21, wherein:

the indoor carbon dioxide concentration is calculated based on an indoor-outdoor ventilation rate of air in the greenhouse; and
the ventilation rate is calculated using a difference between an outdoor specific enthalpy and an indoor specific enthalpy of the greenhouse.

**23.** A computer-readable recording medium in which the computer program according to any one of claims 12 to 22 is recorded.

FIG. 1

1: RESOURCE-RECYCLING GREENHOUSE
HORTICULTURE SIMULATION APPARATUS

FIG. 2

▼ INPUT

RESIDUAL HEAT QUANTITY [ 15,000 ] kcal/h   PLACE NAME [SAPPORO] [POINT SEARCH]

[ ] GJ/h   ☑ USE MINIMUM AIR TEMPERATURE WITHIN CULTIVATION PERIOD

CULTIVATION INFORMATION          HOUSE INFORMATION

KIND OF SCREEN [ LUXOUS + TEMPA ▼ ]

CO2 SUPPLY AMOUNT [ 15 ] kg/h

AVERAGE HEAT-RELEASE COEFFICIENT [ 1.9 ] kcal/m²h℃

KIND OF CROP [ TOMATO ▼ ]

KIND OF ROOF MATERIAL [ FRA ▼ ]

SET NIGHT TEMPERATURE [ 15.5 ] ℃

ROOF SHAPE [ TRIANGULAR ROOF ▼ ]

CULTIVATION START DATE [▦ 09.01 ]

AVERAGE HEAT-RELEASE COEFFICIENT [ 5 ] kcal/m²h℃

| HEAT QUANTITY | KIND OF FUEL : | [ A HEAVY OIL ▼ ] |

CULTIVATION END DATE [▦ 06.30 ]

UNIT PRICE : [ 79 YEN ] /L

LIGHT TRANSMITTANCE [ ] %

KIND · UNIT PRICE INPUT

CO2  KIND OF FUEL : [ LPG ▼ ]

MARKET UNIT PRICE

OPENING [ 8 ] m

UNIT PRICE : [ 256 YEN ] /kg

HEAT QUANTITY [ 2,000 YEN ] /GJ

EAVE HEIGHT [ 5 ] m

CO2 [ 85 YEN ] /kg

SPAN LENGTH [ 5 ] m

FACTORY TRANSACTION UNIT PRICE

ASPECT RATIO [ 1.5 ]

HEAT QUANTITY [ 1,100 YEN ] /GJ

RECYCLING RATE [ 100 ] %

CO2 [ 38 YEN ] /kg

HEATING EFFICIENCY [ 0.9 ]

DESIGN AREA [ 1,000 ] m²

DESIGN COVERAGE AREA [ 1,890.5 ] m²

INPUT SCREEN

FIG. 3

▼ ANNUAL ENERGY USE RESULT BY RESOURCE RECYCLING

| CO2 ABSORPTION AMOUNT | CO2 SUPPLY AMOUNT | CO2 USE RATE |
|---|---|---|
| 10.1t | 40.8t | 25% |

| GREENHOUSE EFFECT GAS EMISSION AMOUNT | ABSENCE OF RESOURCE RECYCLING | PRESENCE OF RESOURCE RECYCLING | EMISSION REDUCTION AMOUNT |
|---|---|---|---|
| HEATING LOAD | 133.5t | 0t | 133.5t |
| CO2 ABSORPTION AMOUNT | 30.7t | −10.1t | 40.8t |

TOTAL REDUCTION AMOUNT = 174.3t

| | ABSENCE OF RESOURCE RECYCLING | PRESENCE OF RESOURCE RECYCLING | REDUCTION ENERGY COST |
|---|---|---|---|
| HEATING COST | ¥3,854,600 | ¥2,120,030 | ¥1,734,570 |
| CO2 ABSORPTION AMOUNT | ¥3,465,450 | ¥1,549,260 | ¥1,916,190 |
| TOTAL | ¥7,320,050 | ¥3,669,290 | |

TOTAL REDUCTION COST = ¥3,650,760

[ FACTORY-SIDE PROCEEDS : ¥3,669,290 ]

OUTPUT SCREEN

FIG. 4

EP 4 685 727 A1

10:EXHAUST HEAT-RECYCLING SIMULATION UNIT

13

**EXHAUST HEAT-USE REDUCTION COST CALCULATION UNIT**

131

FIRST EXHAUST HEAT-USE UNIT PRICE SETTING UNIT
(EXAMPLE: A HEAVY OIL = @¥2,000/GJ)   →   EXAMPLE: ¥3,854,600/YEAR

132

SECOND EXHAUST HEAT-USE UNIT PRICE SETTING UNIT
(EXAMPLE: EXHAUST HEAT = @¥1,100/GJ)   →   EXAMPLE: ¥2,120,030/YEAR

DIFFERENCE = ( EXHAUST HEAT-USE REDUCTION COST EXAMPLE: ¥1,734,570/YEAR )

11

**EXHAUST HEAT-RELATED GREENHOUSE-EFFECT-GAS EMISSION-AMOUNT CALCULATION UNIT**

111

REQUIRED HEAT QUANTITY CALCULATION UNIT

112

HEATING-ORIGIN GREENHOUSE-EFFECT-GAS EMISSION-AMOUNT CALCULATION UNIT

113

RECOVERED HEAT-ORIGIN GREENHOUSE-EFFECT-GAS EMISSION-AMOUNT CALCULATION UNIT

12

**EXHAUST HEAT-USE GREENHOUSE-EFFECT-GAS REDUCTION-AMOUNT CALCULATION UNIT**

(HEATING-ORIGIN GREENHOUSE EFFECT GAS EMISSION AMOUNT (EXAMPLE: 133.56 t))
− (RECOVERED HEAT-ORIGIN GREENHOUSE EFFECT GAS EMISSION AMOUNT (EXAMPLE: 0 t))

OUTPUT → ( EXHAUST HEAT-USE GREENHOUSE EFFECT GAS REDUCTION AMOUNT EXAMPLE: 133.56 t )

FIG. 5

[ PUBLIC WEATHER DATA ]

41 — STRUCTURE INFORMATION DB    42 — PLANT INFORMATION DB    43 — WEATHER INFORMATION DB

[ AVERAGE HEAT-RELEASE COEFFICIENT ] ⌣ S510    [ DESIGN FLOOR AREA ] ⌣ S502    [ DESIGN COVERAGE AREA ] ⌣ S503

[SOIL HEAT-TRANSFER COEFFICIENT] ⌐ S513
+
[ COEFFICIENT × (SET NIGHT TEMPERATURE (AVERAGE) − DAILY NIGHTTIME AVERAGE OUTSIDE AIR TEMPERATURE) ]
=
S511 — [ DAILY SOIL HEAT FLUX ]    ⌣ S512

| NIGHTTIME DEGREE HOUR | ⌣ S504    | DAILY MINIMUM AIR TEMPERATURE    DAILY MAXIMUM AIR TEMPERATURE | ⌣ S501

S506 — [ DAILY SOIL HEAT-TRANSFER AMOUNT ]    [ DAILY NIGHTTIME HEAT-RELEASE AMOUNT ] — S505

[DAILY NIGHTTIME HEATING LOAD] ⌣ S507

[ TOTAL OF DAYS DURING CULTIVATION PERIOD ] ⌣ S508

[ PERIODIC HEAT LOAD ] ⌣ S509

FIG. 6

42

PLANT
INFORMATION
DB

$\begin{bmatrix} \text{PUBLIC WEATHER DATA} \end{bmatrix}$

$\begin{bmatrix} \text{DAILY MAXIMUM} \\ \text{AIR TEMPERATURE} \\ \text{DAILY MINIMUM} \\ \text{AIR TEMPERATURE} \end{bmatrix}$ — S501

$\begin{bmatrix} \text{SET NIGHT TEMPERATURE} \\ \text{(AVERAGE)} \end{bmatrix}$

S601

DAILY MINIMUM AIR
TEMPERATURE ≥ SET NIGHT
TEMPERATURE (AVERAGE)?          No

Yes

$\begin{bmatrix} \text{NIGHTTIME DEGREE HOUR (1)} \end{bmatrix}$ — S602

S603

$\dfrac{7}{12}$ × DAILY MAXIMUM AIR TEMPERATURE + $\dfrac{5}{12}$ ×
DAILY MINIMUM AIR TEMPERATURE > SET NIGHT
TEMPERATURE (AVERAGE)?          No

Yes

S604 — $\begin{bmatrix} \text{NIGHTTIME DEGREE HOUR (2)} \end{bmatrix}$

S605 — $\begin{bmatrix} \text{NIGHTTIME DEGREE HOUR (3)} \end{bmatrix}$

FIG. 7

[PUBLIC WEATHER DATA]

$\left[\begin{array}{c} \text{DAYTIME INDOOR SET TEMPERATURE} \\ - \text{ OUTSIDE AIR TEMPERATURE } - \\ \text{INDOOR SOLAR HEAT EFFECT TEMPERATURE} \end{array}\right]$ ~ S703

S507 ~ [DAILY NIGHTTIME HEATING LOAD]

[DAILY DAYTIME HEATING LOAD] ~ S701

[DAILY PERIODIC HEAT LOAD] ~ S702

[PERIODIC HEAT LOAD] ~ S509

FIG. 8

S509 — PERIODIC HEAT LOAD (= REQUIRED HEAT QUANTITY)
(EXAMPLE: ANNUAL PERIODIC HEAT LOAD = 1734.57 GJ)

↓

S802 — DIVIDED BY HEATING EFFICIENCY (EXAMPLE: 0.9)
(EXAMPLE: 1927.30 GJ)

A HEAVY OIL → EMISSION FACTOR
(0.0189)

S803

S801 — GREENHOUSE EFFECT GAS
EMISSION AMOUNT
133.56 t

FIG. 9

20: EXHAUST GAS-RECYCLING SIMULATION UNIT

$$\text{DIFFERENCE} = \left( \begin{array}{c} \text{EXHAUST GAS-USE} \\ \text{REDUCTION COST} \\ (\text{EXAMPLE}: \text{¥}1,916,190/\text{YEAR}) \end{array} \right)$$

23 — EXHAUST GAS-USE REDUCTION COST CALCULATION UNIT

231 — FIRST EXHAUST GAS-USE UNIT PRICE SETTING UNIT (EXAMPLE: LP = @¥256)
EXAMPLE: ¥3,465,650/YEAR

232 — SECOND EXHAUST GAS-USE UNIT PRICE SETTING UNIT (EXAMPLE: CO2 = @¥38)
EXAMPLE: ¥1,549,260/YEAR

22 — EXHAUST GAS-USE GREENHOUSE-EFFECT-GAS REDUCTION-AMOUNT CALCULATION UNIT

(FOSSIL FUEL-ORIGIN GREENHOUSE EFFECT GAS EMISSION AMOUNT (EXAMPLE: 30.67 t))
− (EXHAUST GAS-ORIGIN GREENHOUSE EFFECT GAS EMISSION AMOUNT (EXAMPLE: −10.10 t))

OUTPUT →
$$\left( \begin{array}{c} \text{EXHAUST GAS-USE GREENHOUSE} \\ \text{EFFECT GAS REDUCTION AMOUNT} \\ \text{EXAMPLE}: 40.77 \text{ t} \end{array} \right)$$

21 — EXHAUST GAS-RELATED GREENHOUSE-EFFECT-GAS EMISSION-AMOUNT CALCULATION UNIT

211 — ABSORPTION AMOUNT CALCULATION UNIT
211a — HOUSE INFORMATION ACQUISITION UNIT
211b — PLANT INFORMATION ACQUISITION UNIT
211c — WEATHER INFORMATION ACQUISITION UNIT
211d — USE RATE CALCULATION UNIT

212 — FOSSIL FUEL-ORIGIN GREENHOUSE-EFFECT-GAS EMISSION-AMOUNT CALCULATION UNIT

213 — EXHAUST GAS-ORIGIN GREENHOUSE-EFFECT-GAS EMISSION-AMOUNT CALCULATION UNIT

FIG. 10

EP 4 685 727 A1

INPUT OF NECESSARY ITEM ⌐S1001

S1002⌐ ACCESS TO
STRUCTURE INFORMATION DB41

ACCESS TO
PLANT INFORMATION DB42

ACCESS TO WEATHER INFORMATION DB43
(or PUBLIC WEATHER DATA) ⌐S1006

S1003⌐ ACQUISITION OF
STRUCTURE INFORMATION

S1004 ACQUISITION OF
PLANT INFORMATION

ACQUISITION OF
WEATHER INFORMATION ⌐S1007

S1005

[ AVERAGE
HEAT-RELEASE
COEFFICIENT ]
[ DESIGN
FLOOR AREA ]
[ DESIGN
COVERAGE AREA ]
[ DAYTIME
VENTILATION
TEMPERATURE ]
[ DAILY DAYTIME
AVERAGE AIR TEMPERATURE ]
[ DAILY
DAY LENGTH ]

S1009⌐ CALCULATION OF
HEAT RETENTION RATIO

CALCULATION OF DAILY DAYTIME
INDOOR AIR TEMPERATURE ⌐S1008

CALCULATION OF DAILY DAYTIME
HEAT-RELEASE AMOUNT ⌐S1010

( A )

FIG. 11

EP 4 685 727 A1

42

CROP = TOMATO → DB

S1113 — δ=0.0002

S1114 — CROP LIGHT INTERCEPTION RATE = 0.85

S1115 — COEFFICIENT OF TRANSFORMATION = 0.0063

S1116 — COEFFICIENT OF TRANSFORMATION = 0.003501946 $m^3$/MJ

S1010 — DAILY DAYTIME HEAT-RELEASE AMOUNT = 7.73839968 MJ/$m^2$

(A)

S1101 — DAILY INCIDENT SOLAR HEAT (MJ/$m^2$) EXAMPLE: CASE OF 1/1 3.468 MJ/$m^2$

43

PLACE NAME = SAPPORO → DB

※ WEATHER DATA FOR A YEAR
DAILY TOTAL GLOBAL SOLAR IRRADIANCE AMOUNT (MJ/$m^2$) EXAMPLE: CASE OF 1/1 5.1 MJ/$m^2$

LIGHT TRANSMITTANCE = 68%

S1101 — DAILY INCIDENT SOLAR HEAT (MJ/$m^2$) EXAMPLE: CASE OF 1/1 3.468 MJ/$m^2$

DAILY SOLAR HEAT BALANCE (MJ/$m^2$) EXAMPLE: CASE OF 1/1 0 MJ/$m^2$

S1102

S1105

DAILY VENTILATION RATE ($m^3$/$m^2$) EXAMPLE: CASE OF 1/1 16.2 $m^3$/$m^2$

PLACE NAME = SAPPORO → DB

43

※ WEATHER DATA FOR A YEAR
DB VALUE | DAILY MAXIMUM AIR TEMPERATURE OF REGION
DB VALUE | DAILY MINIMUM AIR TEMPERATURE OF REGION

S1103 — DAILY OUTDOOR SPECIFIC ENTHALPY (J/kg)

DAILY DAYTIME INDOOR AIR TEMPERATURE (°C) = 21°C

S1104 — DAILY INDOOR SPECIFIC ENTHALPY (J/kg) EXAMPLE: CASE OF 1/1 48198.502 J/kg

S1117 — DAILY INDOOR CO2 CONCENTRATION EXAMPLE: CASE OF 1/1 0.004432509

(B)

41

KIND OF ROOF MATERIAL = FRA → DB

S1008 — GAP VENTILATION RATE_PER HOUR ($m^3$/h$m^2$) = 1.8 $m^3$/h

S1106

PLACE NAME = SAPPORO → DB

43

S1107 — ※ WEATHER DATA FOR A YEAR
DAILY DAY LENGTH (s) = 32400

CO2 SUPPLY AMOUNT (kg/h) = 15 kg/h

DESIGN FLOOR AREA = 1,000 $m^2$

S1108 — CO2 SUPPLY AMOUNT_PER AREA = 0.015 kg/h$m^2$

S1109 — DAILY CO2 SUPPLY AMOUNT_PER AREA (kg/h$m^2$) EXAMPLE: CASE OF 1/1 0.135 kg/$m^2$

S1110 — DAILY CO2 SUPPLY AMOUNT_ PER AREA ($m^3$/$m^2$) EXAMPLE: CASE OF 1/1 0.075042 $m^3$/$m^2$

PLACE NAME = SAPPORO → DB

43

※ WEATHER DATA FOR A YEAR
DAILY DAY LENGTH (s) = 32400

PLACE NAME = SAPPORO → DB

43

S1111 — OUTDOOR CO2 CONCENTRATION OF SELECTED PLACE = 410 ppm

S1112 — OUTDOOR CO2 CONCENTRATION = 0.00041

FIG. 12

EP 4 685 727 A1

CROP = TOMATO → DB (42)

S1101
DAILY INCIDENT SOLAR HEAT (MJ/m²)
EXAMPLE: CASE OF 1/1  3.468 MJ/m²

S1201
CROP LIGHT INTERCEPTION
RATE = 0.85

S1202
δ＝0.0002

S1203
COEFFICIENT OF
TRANSFORMATION = 0.0063

S1204
COEFFICIENT OF
TRANSFORMATION =
0.003501946 m³/MJ

S1117
B → DAILY INDOOR CO2 CONCENTRATION
EXAMPLE:
CASE OF 1/1 0.004432509

S1205
DESIGN FLOOR AREA
= 1,000 m²

S1206
DAILY AMOUNT OF NET
PHOTOSYNTHESIS (m³)
EXAMPLE: CASE OF 1/1
9.877358432 m³

S1207
DAILY AMOUNT OF NET
PHOTOSYNTHESIS (kg)
EXAMPLE: CASE OF 1/1
17.76936782 kg

S1207
DAILY AMOUNT OF NET
PHOTOSYNTHESIS (kg)
EXAMPLE: CASE OF 1/1
17.76936782 kg

CULTIVATION
START DATE  09_01

CULTIVATION
END DATE  06_30

CULTIVATION PERIOD

S1208
DAILY CO2 ABSORPTION
AMOUNT (kg)
EXAMPLE: CASE OF 1/1
17.76936782 kg

→ C

※ NARROW DOWN TO
CULTIVATION PERIOD RANGE

※ MONTHLY TOTAL (kcal)

S1209
C → PERIOD CO2
ABSORPTION AMOUNT_MONTHLY [kg]
EXAMPLE: CASE OF JANUARY
652.4975204 kg

S1210
ANNUAL CO2 ABSORPTION
AMOUNT (kg)
10101.89154 kg

S1211
OUTPUT ITEM No 30 | ANNUAL CO2 ABSORPTION
AMOUNT (kg) 10,101.89154 kg

CONVERSION TO t

S1209
PERIOD CO2
ABSORPTION AMOUNT_MONTHLY [t]
EXAMPLE: CASE OF JANUARY
0.65249752 t

※ MONTHLY TOTAL (t)

S1210
ANNUAL CO2 ABSORPTION
AMOUNT (t)
10.10189154 t

S1211
OUTPUT ITEM No 30 | ANNUAL CO2 ABSORPTION
AMOUNT (t) 10.10189154 t

## FIG. 13

FIG. 13

- CO2 SUPPLY AMOUNT (kg/h) = 15 kg/h
- DESIGN FLOOR AREA = 1,000 m²
- PLACE NAME = SAPPORO

S1301: CO2 SUPPLY AMOUNT PER AREA = 0.015 kg/hm²

DB 43

※ WEATHER DATA FOR A YEAR
S1302: DAILY DAY LENGTH (s)
EXAMPLE: CASE OF 1/1 32400

S1303: DAILY CO2 SUPPLY AMOUNT PER AREA (kg/m²)
EXAMPLE: CASE OF 1/1 0.135 kg/m²

DESIGN FLOOR AREA = 1,000 m²

S1304: DAILY CO2 SUPPLY AMOUNT (kg)
EXAMPLE: CASE OF 1/1 135 kg

CULTIVATION PERIOD
- CULTIVATION START DATE 09_01
- CULTIVATION END DATE 06_30

※ NARROW DOWN TO CULTIVATION PERIOD RANGE

S1304: DAILY CO2 SUPPLY AMOUNT (kg)
EXAMPLE: CASE OF 1/1 135 kg

A

A
- MONTHLY INFORMATION
- MONTHLY_YY

S1305: PERIOD CO2 SUPPLY AMOUNT_MONTHLY [kg]
EXAMPLE: CASE OF JANUARY 4,185 kg

CONVERSION TO t

S1305: PERIOD CO2 SUPPLY AMOUNT_MONTHLY [t]
EXAMPLE: CASE OF JANUARY 4,185 t

S1306: ANNUAL CO2 SUPPLY AMOUNT (kg) 40770 kg

S1306: ANNUAL CO2 SUPPLY AMOUNT (t) 40.77 t

S1307: OUTPUT ITEM No 31 | ANNUAL CO2 SUPPLY AMOUNT (kg) 40,770 kg

S1307: OUTPUT ITEM No 31 | ANNUAL CO2 SUPPLY AMOUNT (t) 40.77 t

FIG. 14

EP 4 685 727 A1

## INTERNATIONAL SEARCH REPORT

| International application No. |
|---|
| **PCT/JP2023/044185** |

**A. CLASSIFICATION OF SUBJECT MATTER**

*G06Q 50/02*(2024.01)i
FI: G06Q50/02

According to International Patent Classification (IPC) or to both national classification and IPC

**B. FIELDS SEARCHED**

Minimum documentation searched (classification system followed by classification symbols)

G06Q10/00-99/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2011-185520 A (OSAKA GAS CO., LTD.) 22 September 2011 (2011-09-22) entire text, all drawings | 1-23 |
| A | JP 2004-362212 A (IDEMITSU KOSAN CO., LTD.) 24 December 2004 (2004-12-24) entire text, all drawings | 1-23 |
| A | JP 2022-056168 A (SOFTBANK CORP.) 08 April 2022 (2022-04-08) entire text, all drawings | 1-23 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 January 2024** | **16 January 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/044185**

| Patent document cited in search report | | | Publication date (day/month/year) | Patent family member(s) | | | Publication date (day/month/year) |
|---|---|---|---|---|---|---|---|
| JP | 2011-185520 | A | 22 September 2011 | (Family: none) | | | |
| JP | 2004-362212 | A | 24 December 2004 | (Family: none) | | | |
| JP | 2022-056168 | A | 08 April 2022 | US entire text, all drawings WO | 2023/288388 2022/071411 | A1 A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006212524 A
- JP 3236723 A

- JP 2021133314 A

**Non-patent literature cited in the description**

- *Tomato grows more and more rapidly with CO2! What is the latest technology of killing three birds with one stone?*, 13 April 2021, vol. 25, https://ene-fro.com/article/ef195_a1

- **MAKIO HAYASHI** ; **TOYOKI KOZAI**. Comparison of Actual and Calculated Heating Degree Hours and a Proposition of Heating Degree Hour Diagram. *Journal of Agricultural Meteorology (J. Agr. Met.)*, 1982, vol. 38 (1), 29-36